# EUROPÄISCHE PATENTSCHRIFT

(11) **EP 3 222 675 B1**
(45) Veröffentlichungstag und Bekanntmachung des Hinweises auf die Patenterteilung: **29.08.2018**
(21) Anmeldenummer: 17158626.6
(22) Anmeldetag: 01.03.2017
(51) Int. Cl.: C09B 45/18, C09B 45/22, C09B 67/04, C09B 67/48, C09B 67/22

(54) **METALLAZOPIGMENTE**
METAL AZO PIGMENTS
PIGMENTS AZOÏQUES MÉTALLIQUES

(30) Priorität: 23.03.2016 EP 16161854
(43) Veröffentlichungstag der Anmeldung: 27.09.2017
(73) Patentinhaber: Lanxess Deutschland GmbH, 50569 Köln (DE)
(72) Erfinder: BORST, Hans-Ulrich, 50189 Elsdorf (DE); LINKE, Frank, 51069 Köln (DE); ENDERT, Sabine, 42327 Wuppertal (DE)

(56) Entgegenhaltungen:
- EP-A1- 1 591 489
- EP-A1- 2 682 434

## Beschreibung

Die vorliegende Erfindung betrifft neue gelbe Metallazopigmente auf Basis mindestens zweier Metallazoverbindungen die sich mindestens in der Art des Metalls voneinander unterscheiden, Verfahren zu deren Herstellung und deren Verwendung als Gelbpigment in Pigmentpräparationen

Die Herstellung von Metallkomplexen aus Azobarbitursäure mit Nickelsalzen und deren Verwendung als gelbe Pigmente ist lange bekannt und vielfach in der Literatur beschrieben (vgl. z.B. W. Herbst, K. Hunger: Industrial Organic Pigments, 3. Auflage 2004, S. 390/397). Es ist weiterhin bekannt, dass diese Produkte weiter umgesetzt werden können, z.B. mit Melamin oder Melaminderivaten, um die anwendungstechnischen Eigenschaften der Pigmente beispielsweise bei der Einfärbung von Kunststoffen, Lacken und Farbfiltern für LCDs zu verbessern.

Des Weiteren ist in der Literatur beschrieben, dass zur Anpassung coloristischer Eigenschaften außer Nickelsalzen auch ein oder mehrere Salze unterschiedlicher Metalle mitverwendet werden können. Die Veröffentlichung EP-A 1 591 489 beschreibt Metallkomplexe von Azoverbindungen, die als Metalle solche aus der Reihe der Alkalimetalle, Erdalkalimetalle, der Lanthanoiden sowie Aluminium, Scandium, Titan, Vanadium, Chrom, Mangan, Kobalt, Kupfer, Nickel und Zink und gegebenenfalls Eisen enthalten. Die erhaltenen Pigmente weisen einen unterschiedlichen Farbort auf im Vergleich zu den reinen Nickel-Azobarbitursäurekomplexen.

In der Druckschrift EP-A1 2682434 werden ähnliche Metallazopigmente beschrieben, die in Pigmentpräparationen besonders gute Dispergierbarkeit und hohe Farbstärken aufweisen und insbesondere zur Herstellung von Farbfiltern Verwendung finden. Durch eine gezielte Oberflächenbelegung der Metallazopigment kann ebenfalls eine Verbesserung anwendungsbezogener Eigenschaften erzielt werden, speziell die Erniedrigung der Dispergierhärte als einem Maß für die Disperiereigenschaften des Pigments. Mit diesem Verfahren zur Verbesserung der Dispergierbarkeit ist jedoch eine Reduzierung der Farbstärke des Pigments verbunden, die in direkter Abhängigkeit von der Konzentration an Belegungsmittel steht.

Eine weitere Möglichkeit der Anpassung anwendungsbezogener Eigenschaften ist es die aus Nickel-Azobarbitursäurekomplexe mit z.B. Melamin hergestellten Pigmente zu tempern. Mit diesem Verfahrensschritt ist eine gezielte Änderung der Teilchengröße der Pigmente und deren spezifischer Oberfläche verbunden. Dieses Verfahren ist z.B. in EP-A 0 994 162 beschrieben.

Die aus dem Stand der Technik bekannten Metallazopigmente sind hinsichtlich ihrer anwendungstechnischen Eigenschaften allerdings noch verbesserungsbedürftig.

Darüber hinaus besteht auch aus ökologischen Gründen der dringende Wunsch, Metallazopigmente mit einem möglichst geringen Gehalt an Nickelionen oder sogar vollständig nickelfreie Produkte für diese Anwendungen bereit zu stellen.

Es wurde gefunden, dass Metallazopigmente auf Basis von Azobarbitursäure, Zink- und Kupfersalzen und Melamin und/oder Melaminderivaten und mindestens einem weiteren, von Zink- und Kupfersalzen unterschiedlichen Metallsalz, überraschender Weise verbesserte Dispergiereigenschaften bei gleichzeitiger Erhöhung der Farbstärke aufweisen. Die Verbesserung dieser Eigenschaften ermöglichen den verbesserten Einsatz dieser Produkte u.a. zur Kunststoff- und Lackeinfärbung, zur Verwendung im InkJet und als Komponente von Farbfiltern für LCDs.

Die Erfindung betrifft daher Metallazopigmente, dadurch gekennzeichnet, dass sie enthalten die Komponenten
a) mindestens zwei Metallazoverbindungen die sich mindestens in der Art des Metalls voneinander unterscheiden und die jeweils
   - Struktureinheiten der Formel (I), oder deren tautomeren Formen, 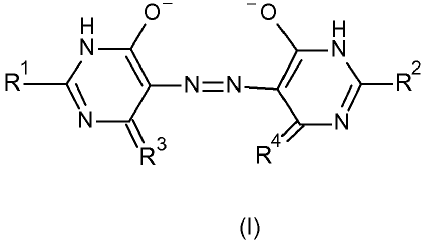 worin
      R¹ und R² unabhängig voneinander für OH, NH₂ oder NHR⁵ stehen,
      R³ und R⁴ unabhängig voneinander für =O oder =NR⁵ stehen,
      R⁵ für Wasserstoff oder Alkyl, vorzugsweise C₁-C₄-Alkyl, steht,
         und
   - Zn²⁺- beziehungsweise Cu²⁺- Metallionen und gegebenenfalls mindestens ein weiteres Metallion Me, wobei Me für ein 2- oder 3-wertiges, von Zn²⁺ und Cu²⁺ verschiedenes Metallion steht, mit der Maßgabe, dass die Menge an Zn²⁺- und Cu²⁺-Metallionen zusammen 95 bis 100 Mol-% beträgt und die Menge an 2- oder 3-wertigen, von Zn²⁺ und Cu²⁺ verschiedenen Metallionen 0 bis 5 Mol-% beträgt, jeweils bezogen auf ein Mol aller Metallionen im Metallazopigment,
      wobei das Molverhältnis von Zn²⁺- zu Cu²⁺- Metallionen im Metallazopigment 199 : 1 bis 1 : 15, bevorzugt 19 : 1 bis 1 : 1 und besonders bevorzugt 9 : 1 bis 2 : 1,
      beträgt,
      und
b) mindestens eine Verbindung der Formel (II) 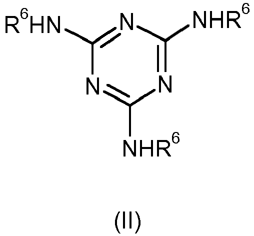 worin
   R⁶ für Wasserstoff oder Alkyl, vorzugsweise C₁-C₄-Alkyl das gegebenenfalls ein- oder mehrfach durch OH substituiert ist, steht.
   Vorzugsweise stehen in Formel (I) R¹ und R² unabhängig voneinander für OH, NH₂ oder NHR⁵, wobei R⁵ für Wasserstoff oder C₁-C₄-Alkyl, steht.
   Vorzugsweise stehen in Formel (I) R³ und R⁴ unabhängig voneinander für =O oder =NR⁵, wobei R⁵ für Wasserstoff oder C₁-C₄-Alkyl steht.

Besonders bevorzugt stehen in Formel (I) R¹ und R² für OH und R³ und R⁴ für =O.

Vorzugsweise steht in Formel (II) R⁶ für Wasserstoff oder C₁-C₄-Alkyl das gegebenenfalls ein- oder mehrfach durch OH substituiert ist. Besonders bevorzugt steht in Formel (II) R⁶ für Wasserstoff.

Bezogen auf ein Mol aller im Metallazopigment vorhandenen Metallionen beträgt die Menge an Cu²⁺-und Zn²⁺-Ionen zusammen allgemein 95 bis 100 Mol-% und die Menge an Metallionen Me 0 bis 5 Mol-%, vorzugsweise beträgt die Menge an Cu²⁺- und Zn²⁺-Ionen zusammen 98 bis 100 Mol-% und die Menge an Metallionen Me 0 bis 2 Mol-%, besonders bevorzugt beträgt die Menge an Cu²⁺-und Zn²⁺-Ionen zusammen 99,9 bis 100 Mol-% und die Menge an Metallionen Me 0 bis 0,1 Mol-% und insbesondere beträgt die Menge an Cu²⁺-und Zn²⁺-Ionen zusammen 100 Mol-%.

Allgemein beträgt das Molverhältnis von Zn²⁺- zu Cu²⁺- Metallionen im Metallazopigment 199 : 1 bis 1 : 15, bevorzugt 19 : 1 bis 1 : 1 und besonders bevorzugt 9 : 1 bis 2 : 1.

Substituenten in der Bedeutung von Alkyl bezeichnen beispielsweise geradkettiges oder verzweigtes C₁-C₆-Alkyl, vorzugsweise geradkettiges oder verzweigtes C₁-C₄-Alkyl, das gegebenenfalls ein- oder mehrfach, gleich oder verschieden substituiert sein kann, beispielsweise durch Halogen, wie Chlor, Brom oder Fluor, sowie durch -OH, -CN, -NH₂ oder C₁-C₆-Alkoxy.

Die Metallionen Me liegen vorzugsweise in ihren stabilsten Oxidationsstufen vor.

Bevorzugt steht Me für ein Metallion ausgewählt aus der Reihe Ni²⁺, Al³⁺, Fe²⁺, Fe³⁺, Co²⁺, Co³⁺, La³⁺, Ce³⁺, Pr³⁺, Nd²⁺, Nd³⁺, Sm²⁺, Sm³⁺, Eu²⁺, Eu³⁺, Gd³⁺, Tb³⁺, Dy³⁺, Ho³⁺, Yb²⁺, Yb³⁺, Er³⁺, Tm³⁺, Mg²⁺, Ca²⁺, Sr²⁺, Mn²⁺, Y³⁺, Sc³⁺, Ti²⁺, Ti³⁺, Nb³⁺, Mo²⁺, Mo³⁺, V²⁺, V³⁺, Zr²⁺, Zr³⁺, Cd²⁺, Cr³⁺, Pb²⁺, Ba²⁺, besonders bevorzugt aus der Reihe Al³⁺, Fe²⁺, Fe³⁺, Co²⁺, Co³⁺, La³⁺, Ce³⁺, Pr³⁺, Nd³⁺, Sm³⁺, Eu³⁺, Gd³⁺, Tb³⁺, Dy³⁺, Ho³⁺, Yb³⁺, Er³⁺, Tm³⁺, Mg²⁺, Ca²⁺, Sr²⁺, Mn²⁺, Y³⁺, ganz besonders bevorzugt aus der Reihe Al³⁺, Fe²⁺, Fe³⁺, Co²⁺, Co³⁺, La³⁺, Ce³⁺, Pr³⁺, Nd³⁺, Sm³⁺, Tb³⁺, Ho³⁺, Sr²⁺ und insbesondere aus der Reihe Al³⁺, Fe²⁺, Fe³⁺, Co²⁺und Co³.

Im Fall, dass Metallazoverbindungen der Komponente a) 2-wertige Metallionen Me enthalten, können die Struktureinheiten der Formel (I) und die Metallionen Me als Verbindungen der Formel (Ia) 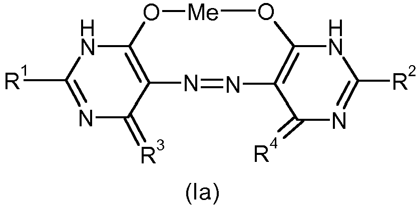 aufgefasst werden. Es ist aber auch möglich, dass das Metallion in einer tautomeren Schreibweise der Formel (Ia) über die Stickstoffatome gebunden ist.

Die gleiche formelmäßige Darstellung kann auf die Struktureinheiten der Formel (I) mit den Cu²⁺-Ionen bzw. mit den Zn²⁺-Ionen angewendet werden. Diese Darstellung dient nur zur Veranschaulichung und erhebt keinen Anspruch auf wissenschaftliche Korrektheit.

Im Fall, dass Me für ein 3-wertiges Metallion steht erfolgt der Ladungsausgleich durch eine äquivalente Menge an anionischen Struktureinheiten der Formel (I).

Vorzugsweise erfolgt der Ladungsausgleich der zweifach negativ geladenen Struktureinheiten der Formel (I) zu 80 bis 100%, besonders bevorzugt zu 95 bis 100% und ganz besonders bevorzugt zu 99,9 bis 100% durch die Summe aller im Metallazopigment vorhandenen Cu²⁺, Zn²⁺ und gegebenenfalls weiteren Metallionen Me.

Vorzugsweise bilden die genannten Metallazoverbindungen der Komponenten a) mit den Komponenten b), d.h. den Verbindungen der Formel (II), Addukte.

Als Addukte sind dabei generell zusammengesetzte Moleküle zu verstehen. Dabei kann die Bindung zwischen den Molekülen beispielsweise durch intermolekulare Wechselwirkungen oder Lewis-Säure-Base Wechselwirkungen oder durch koordinative Bindungen erfolgen.

Der Begriff Addukt soll im Sinne der vorliegenden Erfindung generell alle Arten von Ein- und Anlagerungsverbindungen umfassen.

Unter den Begriffen "Einlagerungsverbindung" oder "Anlagerungsverbindung" im Sinne der vorliegenden Erfindung sollen beispielsweise Verbindungen verstanden werden, die aufgrund von intermolekularen Wechselwirkungen wie Van-der Waals-Wechselwirkungen oder auch Lewis-Säure-Base Wechselwirkungen gebildet werden. Dabei hängt es sowohl von den chemischen Eigenschaften der einzulagernden Komponente, aber auch von der chemischen Natur des Wirtsgitters ab, wie die Einlagerung abläuft. Solche Verbindungen werden häufig auch als Interkalationsverbindungen bezeichnet. Im chemischen Sinn versteht man darunter die Einlagerung von Molekülen, Ionen (selten auch Atomen) in chemische Verbindungen.

Weiterhin sollen darunter auch Einschlussverbindungen, sogenannte Clathrate, verstanden werden. Diese stellen Verbindungen zweier Stoffe dar, von denen ein Gastmolekül in ein Gitter oder Käfig aus einem Wirtsmolekül eingelagert ist.

Unter den Begriffen "Einlagerungsverbindung" oder "Anlagerungsverbindung" im Sinne der vorliegenden Erfindung sollen auch Einlagerungsmischkristalle (auch interstitielle Verbindung) verstanden werden. Es handelt es sich hierbei um chemische, nichtstöchiometrische, kristalline Verbindungen aus mindestens zwei Elementen.

Weiterhin sollen unter den Begriffen "Einlagerungsverbindung" oder "Anlagerungsverbindung" im Sinne der vorliegenden Erfindung auch Verbindungen verstanden werden, die aufgrund von koordinativen Bindungen oder Komplexbindungen gebildet werden. Als solche Verbindungen werden z.B. Substitutionsmischkristall oder Austauschmischkristall bezeichnet, bei dem mindestens zwei Stoffe einen gemeinsamen Kristall bilden und die Atome der zweiten Komponente auf regulären Gitterplätzen der ersten Komponente sitzen.

Bevorzugt sind Metallazopigmente enthaltend die Addukte aus
a) mindestens zwei Metallazoverbindungen die sich mindestens in der Art des Metalls unterscheiden und die jeweils Struktureinheiten der oben angegebenen Formel (I),
   worin R¹ und R² für OH stehen,
   und
   R³ und R⁴ für =O stehen,
   und
   Zn²⁺- beziehungsweise Cu²⁺- Metallionen und gegebenenfalls mindestens ein weiteres Metallion Me enthalten,
   wobei
   Me für ein Metallion ausgewählt aus der Reihe Ni²⁺, Al³⁺, Fe²⁺, Fe³⁺, Co²⁺, Co³⁺, La³⁺, Ce³⁺, Pr³⁺, Nd²⁺, Nd³⁺, Sm²⁺, Sm³⁺, Eu²⁺, Eu³⁺, Gd³⁺, Tb³⁺, Dy³⁺, Ho³⁺, Yb²⁺, Yb³⁺, Er³⁺, Tm³⁺, Mg²⁺, Ca²⁺, Sr²⁺, Mn²⁺, Y³⁺, Sc³⁺, Ti²⁺, Ti³⁺, Nb³⁺, Mo²⁺, Mo³⁺, V²⁺, V³⁺, Zr²⁺, Zr³⁺, Cd²⁺, Cr³⁺, Pb²⁺, Ba²⁺, besonders bevorzugt aus der Reihe Al³⁺, Fe²⁺, Fe³⁺, Co²⁺, Co³⁺, La³⁺, Ce³⁺, Pr³⁺, Nd³⁺, Sm³⁺, Eu³⁺, Gd³⁺, Tb³⁺, Dy³⁺, Ho³⁺, Yb³⁺, Er³⁺, Tm³⁺, Mg²⁺, Ca²⁺, Sr²⁺, Mn²⁺, Y³⁺, ganz besonders bevorzugt aus der Reihe Al³⁺, Fe²⁺, Fe³⁺, Co²⁺, Co³⁺, La³⁺, Ce³⁺, Pr³⁺, Nd³⁺, Sm³⁺, Tb³⁺, Ho³⁺, Sr²⁺ und insbesondere aus der Reihe Al³⁺, Fe²⁺, Fe³⁺, Co²⁺und Co³ steht,
   mit der Maßgabe, dass die Menge an Zn²⁺- und Cu²⁺- Metallionen zusammen 95 bis 100 Mol-% beträgt und die Menge an Metallionen Me 0 bis 5 Mol-% beträgt, jeweils bezogen auf ein Mol aller Metallionen im Metallazopigment,
   und
   wobei das Molverhältnis von Zn²⁺- zu Cu²⁺- Metallionen im Metallazopigment 199 : 1 bis 1 : 15, bevorzugt 19 : 1 bis 1 : 1 und besonders bevorzugt 9 : 1 bis 2 : 1, beträgt
   und
b) mindestens einer Verbindung der oben angegebenen Formel (II)
   worin
   R⁶ für Wasserstoff steht.

Besonders bevorzugt sind Metallazopigmente enthaltend die Addukte aus
a) mindestens zwei Metallazoverbindungen die sich mindestens in der Art des Metalls unterscheiden und die jeweils Struktureinheiten der oben angegebenen Formel (I),
   worin
   R¹, R², R³, R⁴ und R⁵ die oben angegebenen allgemeinen und bevorzugte Bedeutung haben,
   und
   Zn²⁺- beziehungsweise Cu²⁺- Metallionen enthalten,
   mit der Maßgabe, dass die Menge an Cu²⁺- und Zn²⁺-Metallionen zusammen 100 Mol-% beträgt, bezogen auf ein Mol aller Metallionen im Metallazopigment,
   und
   wobei das Molverhältnis von Zn²⁺- zu Cu²⁺- Metallionen im Metallazopigment 199 : 1 bis 1 : 15, bevorzugt 19 : 1 bis 1 : 1 und besonders bevorzugt 9 : 1 bis 2 : 1 beträgt,
   und
b) mindestens einer Verbindung der oben angegebenen Formel (II) worin
   R⁶ die oben angegebenen allgemeinen und bevorzugten Bedeutungen hat.

Verbindung, die geeignet sind mit den Metallazoverbindungen der Komponente a) ein Addukt im Sinne der obigen Definition zu bilden können sowohl organische als auch anorganische Verbindungen sein. Im Folgenden werden diese Verbindungen als Adduktbildner bezeichnet.

Prinzipiell geeignete Adduktbildner entstammen den verschiedenartigsten Verbindungsklassen. Aus rein praktischen Gründen sind solche Verbindungen bevorzugt, die unter Normalbedingungen (25°C, 1 bar) flüssig oder fest sind.

Von den flüssigen Substanzen sind generell solche bevorzugt, die einen Siedepunkt von 100°C oder darüber, bevorzugt von größer gleich 150°C bei 1 bar, aufweisen. Geeignete Adduktbildner sind generell acyclische und cyclische organische Verbindungen, z.B. aliphatische und aromatische Kohlenwasserstoffe, die substituiert sein können, z.B. durch OH, COOH, NH₂, substituiertes NH₂, CONH₂, substituiertes CONH₂, SO₂NH₂, substituiertes SO₂NH₂, SO₃H, Halogen, NO₂, CN, -SO₂-Alkyl, -SO₂-Aryl, -O-Alkyl, -O-Aryl, -O-Acyl.

Carbonsäure- und Sulfonsäureamide sind eine bevorzugte Gruppe von Adduktbildnern, insbesondere geeignet sind auch Harnstoff und substituierte Harnstoffe wie Phenylharnstoff, Dodecylharnstoff und andere sowie deren Polykondensate mit Aldehyden, insbesondere Formaldehyd; Heterocyclen wie Barbitursäure, Benzimidazolon, Benzimidazolon-5-sulfonsäure, 2,3-Dihydroxychinoxalin, 2,3-Dihydroxychinoxalin-6-sulfonsäure, Carbazol, Carbazol-3,6-disulfonsäure, 2-Hydroxychinolin, 2,4-Dihydroxychinolin, Caprolactam, Melamin, 6-Phenyl-1,3,5-triazin-2,4-diamin, 6-Methyl-1,3,5-triazin-2,4-diamin, Cyanursäure.

Ebenfalls als Adduktbildner prinzipiell geeignet sind Polymere, vorzugsweise wasserlösliche Polymere, z.B. Ethylen-propylenoxid-Blockpolymere, vorzugsweise mit einem Mₙ größer gleich 1.000, insbesondere von 1.000 bis 10.000 g/mol, Polyvinylalkohol, Poly-(meth)-acrylsäuren, modifizierte Cellulose, wie Carboxymethylcellulosen, Hydroxyethyl- und -propylcellulosen, Methyl- und Ethylhydroxyethylcellulosen.

Erfindungsgemäß werden als Adduktbildner solche der Formel (II) eingesetzt. Insbesondere bevorzugt ist dabei Melamin.

Im Allgemeinen enthalten die erfindungsgemäßen Metallazopigmente pro Mol an Struktureinheiten der Formel (I) 0,05 bis 4 Mol, bevorzugt 0,5 bis 2,5 Mol und ganz besonders bevorzugt 1,0 bis 2,0 Mol an Verbindungen der Formel (II).

Die erfindungsgemäßen Metallazopigmente besitzen vorzugsweise eine spezifische Oberfläche (m²/g) von 20 bis 200 m²/g, insbesondere 60 bis 160 m²/g, ganz besonders bevorzugt 90 bis 150 m²/g. Die Oberfläche wird nach DIN 66131 ermittelt: Bestimmung der spezifischen Oberfläche von Feststoffen durch Gasadsorption nach Brunauer, Emmett und Teller (B.E.T).

Bei den erfindungsgemäßen Metallazopigmenten kann es sich um physikalische Mischungen oder um chemische Mischverbindungen handeln. Vorzugsweise handelt es sich bei den physikalischen Mischungen um Mischungen von Addukten aus den genannten Metallazoverbindungen der Komponente a) und den Verbindungen der Formel (II) der Komponente b) die sich zumindest hinsichtlich der Art der Metalle unterscheiden. Beispielsweise und bevorzugt handelt es sich um die physikalische Mischung der Addukte aus a1) der reinen Zn-Azoverbindung mit b1) Melamin und der Addukte aus a2) der reinen Cu-Azoverbindung mit b2) Melamin und gegebenenfalls der Addukte aus a3) mindestens einer weiteren Me-Azoverbindung mit b3) Melamin. Bei den chemischen Mischverbindungen handelt es sich beispielsweise und bevorzugt um Addukte von Metallazoverbindungen der Komponente a) mit Verbindungen der Formel (II) der Komponente b), vorzugsweise Melamin, bei denen die Zn²⁺- und Cu²⁺-Ionen, und gegebenenfalls weitere Metallion Me, in ein gemeinsames Kristallgitter eingebaut sind.

Im Fall der vorliegenden Erfindung unterscheiden sich die Röntgendiffraktogramme der physikalischen Mischungen und der chemischen Mischverbindungen nicht.

Die erfindungsgemäßen Metallazopigmente zeichnen sich durch charakteristische Signale im Röntgendiffraktogramm aus. Insbesondere dadurch, dass das Metallazopigment im Röntgendiffraktogramm zwischen den Netzebenenabständen von d = 14,7 (± 0,3) Å und d = 11,8 (± 0,3) Å mindestens ein Signal S mit der Intensität I aufweist, das den Wert des Untergrundes um das 3-fache der Wurzel dieses Wertes übersteigt.

Die erfindungsgemäßen Metallazopigmente, bei denen das Molverhältnis von Zn²⁺- zu Cu²⁺- Metallionen in einem Mol aller Metallionen 1 : 15 bis 4 : 1 beträgt, zeichnen sich dadurch aus, dass sie im Röntgendiffraktogramm bei einem Netzebenenabstand von d = 12,3 (± 0,3) Å ein Signal S₁ mit einer Intensität I₁ und gleichzeitig bei einem Netzebenenabstand von d = 3,7 (± 0,3) Å ein Signal S₂ mit einer Intensität I₂ aufweisen, das jeweils den Wert des Untergrundes um das 3-fache der Wurzel dieses Wertes übersteigt.

Die erfindungsgemäßen Metallazopigmente können hergestellt werden durch Umsetzung von Alkalisalzen der Formel (III), oder deren Tautomeren, bevorzugt der Natrium- oder Kaliumsalze, in Gegenwart von mindestens einer Verbindung der Formel (II) mit Zink- und Kupfersalzen und gegebenenfalls einem oder mehreren Metallsalzen von 2- oder 3-wertigen, von Zink und Kupfer und verschiedenen Metallen, bevorzugt aus der Reihe der Nickel-, Aluminium-, Eisen-, Kobalt-, Lanthan-, Cer-, Praseodym-, Neodym-, Samarium-, Europium-, Gadolinium-, Terbium, Dysprosium-, Holmium-, Ytterbium-, Erbium-, Thulium-, Magnesium-, Kalzium-, Strontium-, Mangan-, Yttrium-, Scandium-, Titan-, Niob-, Molybdän-, Vanadium-, Zirkonium-, Cadmium-, Chrom-, Blei- und Bariumsalze, besonders bevorzugt aus der Reihe der Nickel-, Aluminium-, Eisen-, Kobalt-, Lanthan-, Cer-, Praseodym-, Neodym-, Samarium-, Europium-, Gadolinium-, Terbium, Dysprosium-, Holmium-, Ytterbium-, Erbium-, Thulium-, Magnesium-, Kalzium-, Strontium-, Mangan-, Yttriumsalze, ganz besonders bevorzugt aus der Reihe der Nickel-, Aluminium-, Eisen-, Kobalt-, Lanthan-, Cer-, Praseodym-, Neodym-, Samarium-, Terbium, Holmium-, Strontiumsalze und insbesondere aus der Reihe der Nickel-, Aluminium-, Eisen- und Kobaltsalze.

Die erfindungsgemäßen Metallazopigmente können auch hergestellt werden durch Mischen der Addukte aus a1) Metallazoverbindungen die Struktureinheiten der Formel (I) und Zn²⁺-Ionen enthalten und b1) Verbindungen der Formel (II) mit Addukten aus a2) Metallazoverbindungen die Struktureinheiten der Formel (I) und Cu²⁺-Ionen enthalten und b2) Verbindungen der Formel (II), gegebenenfalls mit Addukten a3) aus Metallazoverbindungen die Sturktureinheiten der Formel (I) und Metallionen Me enthalten und b3) Verbindungen der Formel (II).

Weiterer Gegenstand der vorliegenden Erfindung ist ein Verfahren zur Herstellung der erfindungsgemäßen Metallazopigmente das dadurch gekennzeichnet ist, dass man mindestens eine Verbindung der Formel (III), oder deren Tautomere, 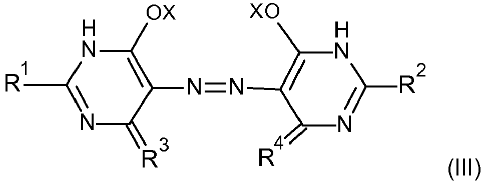 worin
X für ein Alkalimetallion, vorzugsweise für ein Natrium- oder Kaliumion steht,
R¹ und R² unabhängig voneinander für OH, NH₂ oder NHR⁵ stehen,
R³ und R⁴ unabhängig voneinander für =O oder =NR⁵ stehen,
   und
R⁵ für Wasserstoff oder Alkyl, bevorzugt C₁-C₄-Alkyl, steht,

in Gegenwart von mindestens einer Verbindung der Formel (II) gleichzeitig oder nacheinander mit mindestens einem Zinksalz und mindestens einem Kupfersalz und gegebenenfalls mit mindestens einem weiteren Metallsalz eines 2- oder 3-wertigen, von Zink und Kupfer verschiedenen Metalles, bevorzugt aus der Reihe der Ni²⁺-, Al³⁺-, Fe²⁺-, Fe³⁺-, Co²⁺-, Co³⁺-, La³⁺-, Ce³⁺-, Pr³⁺-, Nd²⁺-, Nd³⁺-, Sm²⁺-, Sm³⁺-, Eu²⁺-, Eu³⁺-, Gd³⁺-, Tb³⁺-, Dy³⁺-, Ho³⁺-, Yb²⁺-, Yb³⁺-, Er³⁺-, Tm³⁺-, Mg²⁺-, Ca²⁺-, Sr²⁺-, Mn²⁺-, Y³⁺-, Sc³⁺-, Ti²⁺-, Ti³⁺-, Nb³⁺-, Mo²⁺-, Mo³⁺-, V²⁺-, V³⁺-, Zr²⁺-, Zr³⁺-, Cd²⁺-, Cr³⁺-, Pb²⁺- und Ba²⁺-Salze, besonders bevorzugt aus der Reihe Al³⁺-, Fe²⁺-, Fe³⁺-, Co²⁺- , Co³⁺-, La³⁺-, Ce³⁺-, Pr³⁺-, Nd³⁺-, Sm³⁺-, Eu³⁺-, Gd³⁺-, Tb³⁺-, Dy³⁺-, Ho³⁺-, Yb³⁺-, Er³⁺-, Tm³⁺-, Mg²⁺-, Ca²⁺-, Sr²⁺-, Mn²⁺- und Y³⁺-Salze, ganz besonders bevorzugt aus der Reihe Al³⁺-, Fe²⁺-, Fe³⁺-, Co²⁺-, Co³⁺-, La³⁺-, Ce³⁺-, Pr³⁺-, Nd³⁺-, Sm³⁺-, Tb³⁺-, Ho³⁺- und Sr²⁺- Salze und insbesondere aus der Reihe Al³⁺-, Fe²⁺-, Fe³⁺-, Co²⁺- und Co³⁺- Salze umsetzt, wobei pro Mol an Verbindung der Formel (III) 0,06 bis 0,995 Mol mindestens eines Zinksalzes, 0,005 bis 0,94 Mol mindestens eines Kupfersalzes und 0,05 bis 0 Mol mindestens eines weiteren Metallsalzes von 2- oder 3-wertigen, von Zink und Kupfer verschiedenen Metallen, eingesetzt werden, und wobei die Summe der Molmengen all dieser Metallsalze insgesamt ein Mol beträgt.

Bevorzugt werden pro Mol an Verbindung der Formel (III) 0,05 bis 0,5 Mol mindestens eines Zinksalzes und 0,49 bis 0,95 Mol mindestens eines Kupfersalzes und 0,01 bis 0 Mol mindestens eines weiteren Metallsalzes von 2- oder 3-wertigen, von Zink und Kupfer verschiedenen Metallen, eingesetzt.

Ganz besonders bevorzugt werden pro Mol an Verbindung der Formel (III) 0,1 bis 0,3 Mol mindestens eines Zinksalzes und 0,7 bis 0,9 Mol mindestens eines Kupfersalzes eingesetzt.

Im Allgemeinen werden zur Durchführung des erfindungsgemäßen Verfahrens pro Mol an Verbindung der Formel (III) 0,05 bis 4 Mol, bevorzugt 0,5 bis 2,5 Mol und ganz besonders bevorzugt 1,0 bis 2,0 Mol an Verbindung der Formel (II) eingesetzt.

Alternativ kann zur Herstellung an Stelle der Dialkaliverbindung der Formel (III) auch eine Monoalkaliverbindung der Formel (IIIa), oder deren Tautomere, 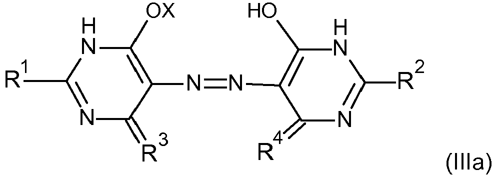 worin X, R¹, R², R³ und R⁴ die für Formel (III) angegebene Bedeutung haben,
oder eine Mischung aus Verbindungen der Formel (III) und (IIIa) eingesetzt werden. Dabei beziehen sich die angegebenen Molmengen an Zink- und Kupfersalzen und gegebenenfalls weiteren, von Zink- und Kupfersalzen verschiedenen Metallsalzen, sowie an Verbindungen der Formel (II) in diesen Fällen auf die Summe der Molmenge der eingesetzten Verbindungen (III) und (IIIa).

Insbesondere bevorzugt ist die Herstellung von binären Zink-/Kupfer- Azobarbitursäure-Melamin Addukten. Das erfindungsgemäße Verfahren wird im Allgemeinen bei einer Temperatur von 60 bis 95 °C in wässriger Lösung bei einem pH-Wert unterhalb von 7 durchgeführt. Die erfindungsgemäß einzusetzenden Zink- und Kupfersalze und die gegebenenfalls einzusetzenden weiteren Metallsalze können einzeln oder als Gemisch untereinander, bevorzugt in Form einer wässrigen Lösung eingesetzt werden. Die Verbindungen der Formel (II) können ebenfalls einzeln oder als Mischung untereinander zugegeben werden, bevorzugt in Form der Feststoffe.

Im Allgemeinen wird das erfindungsgemäße Verfahren so durchgeführt, dass die Azoverbindung der Formel (III), vorzugsweise als Na- oder K-Salz, vorgelegt wird, dass eine oder mehrere Verbindungen der Formel (II), vorzugsweise Melamin, zugegeben werden und danach, gleichzeitig oder nacheinander, mit mindestens einem Zinksalz und mindestens einem Kupfersalz und gegebenenfalls einem oder mehreren Metallsalzen von 2- oder 3-wertigen, von Kupfer und Zink verschiedenen Metallen, vorzugsweise in Form der wässrigen Lösungen dieser Salze, umgesetzt wird, vorzugsweise bei pH-Werten kleiner 7. Zur Einstellung des pH-Wertes eignen sich Natronlauge, Kalilauge, Natriumcarbonat, Natriumhydrogencarbonat, Kaliumcarbonat und Kaliumhydrogencarbonat.

Als Zink- und Kupfersalze kommen vorzugsweise deren wasserlösliche Salze in Frage, insbesondere Chloride, Bromide, Acetate, Formiate, Nitrate, Sulfate usw. Bevorzugt eingesetzte Zink- und Kupfersalze besitzen eine Wasserlöslichkeit von mehr als 20 g/l, insbesondere mehr als 50 g/l bei 20°C.

Als weitere Metallsalze von 2- oder 3-wertigen, von Kupfer und Zink verschiedenen Metallen, vorzugsweise aus der Reihe der Nickel, Aluminium, Eisen, Kobalt, Lanthan, Cer, Praseodym, Neodym, Samarium, Europium, Gadolinium, Terbium, Dysprosium, Holmium, Ytterbium, Erbium, Thulium, Magnesium, Kalzium, Strontium, Mangan, Yttrium, Scandium, Titan, Niob, Molybdän, Vanadium, Zirkonium, Cadmium, Chrom, Blei und Barium, kommen vorzugsweise deren wasserlösliche Salze in Frage, insbesondere deren Chloride, Bromide, Acetate, Nitrate und Sulfate, bevorzugt deren Chloride.

Die auf diese Weise erhaltenen erfindungsgemäßen Metallazopigmente können dann durch Filtration ihrer wässrigen Suspension als wässriger Nutschkuchen isoliert werden. Dieser Nutschkuchen kann, gegebenenfalls nach Waschen mit heißem Wasser, mittels üblicher Trocknungsverfahren getrocknet werden.

Als Trocknungsverfahren kommen beispielsweise die Schaufeltrocknung oder die Sprühtrocknung entsprechender wässriger Slurries in Frage.

Anschließend kann das Pigment nachgemahlen werden.

Sofern die erfindungsgemäßen Metallazopigmente für die gewünschte Anwendung zu kornhart bzw. zu dispergierhart sind, können sie beispielsweise gemäß der in DE-A 19 847 586 beschriebenen Methode in kornweiche Pigmente umgewandelt werden.

Weiterer Gegenstand der vorliegenden Erfindung ist ein Verfahren zur Herstellung der erfindungsgemäßen Metallazopigmenten das dadurch gekennzeichnet ist, dass man
(i) mindestens ein Addukt aus
   a1) einer Metallazoverbindung die Stuktureinheiten der oben angegebenen Formel (I),
      worin
      R¹, R², R³, R⁴ und R⁵ die oben angegebenen allgemeinen und bevorzugten Bedeutung haben,
      und
      Cu²⁺ -Ionen enthält,
      und
   b1) mindestens einer Verbindung der oben angegebenen Formel (II), worin R⁶ die oben angegebenen allgemeinen und bevorzugten Bedeutungen hat,
      und die Menge an Cu²⁺-Metallionen 100 Mol-% beträgt, bezogen auf ein Mol aller Metallionen im Addukt a1)/b1),
      mit
(ii) mindestens einem Addukt aus
   a2) einer Metallazoverbindung die Stuktureinheiten der oben angegebenen Formel (I),
      worin
      R¹, R², R³, R⁴ und R⁵ die oben angegebenen allgemeinen und bevorzugte
      Bedeutung haben,
      und
      Zn²⁺ -Ionen enthält,
      und
   b2) mindestens einer Verbindung der oben angegebenen Formel (II), worin R⁶ die oben angegebenen allgemeinen und bevorzugten Bedeutungen hat,
      und die Menge an Zn²⁺-Metallionen 100 Mol-% beträgt, bezogen auf ein Mol aller Metallionen im Addukt a2)/b2),
      und gegebenenfalls mit
(iii) mindestens einem Addukt aus
   a3) einer Metallazoverbindung die Sturktureinheiten der oben angegebenen Formel (I),
      worin
      R¹, R², R³, R⁴ und R⁵ die oben angegebenen allgemeinen und bevorzugten Bedeutung haben,
      und
      Metallionen Me enthält,
      worin
      Me für ein 2- oder 3-wertiges, von Zn²⁺ und Cu²⁺ verschiedenes Metallion steht, vorzugsweise für ein Metallion ausgewählt aus der Reihe Ni²⁺, Al³⁺, Fe²⁺, Fe³⁺, Co²⁺, Co³⁺, La³⁺, Ce³⁺, Pr³⁺, Nd²⁺, Nd³⁺, Sm²⁺, Sm³⁺, Eu²⁺, Eu³⁺, Gd³⁺, Tb³⁺, Dy³⁺, Ho³⁺, Yb²⁺, Yb³⁺, Er³⁺, Tm³⁺, Mg²⁺, Ca²⁺, Sr²⁺, Mn²⁺, Y³⁺, Sc³⁺, Ti²⁺, Ti³⁺, Nb³⁺, Mo²⁺, Mo³⁺, V²⁺, V³⁺, zr²⁺, Zr³⁺, Cd²⁺, Cr³⁺, Pb²⁺, Ba²⁺,
      besonders bevorzugt aus der Reihe Al³⁺, Fe²⁺, Fe³⁺, Co²⁺, Co³⁺, La³⁺, Ce³⁺, Pr³⁺, Nd³⁺, Sm³⁺, Eu³⁺, Gd³⁺, Tb³⁺, Dy³⁺, Ho³⁺, Yb³⁺, Er³⁺, Tm³⁺, Mg²⁺, Ca²⁺, Sr²⁺, Mn²⁺, Y³⁺, ganz besonders bevorzugt aus der Reihe Al³⁺, Fe²⁺, Fe³⁺, Co²⁺, Co³⁺, La³⁺, Ce³⁺, Pr³⁺, Nd³⁺, Sm³⁺, Tb³⁺, Ho³⁺, Sr²⁺ und insbesondere aus der Reihe Al³⁺, Fe²⁺, Fe³⁺, Co²⁺und Co³⁺
      steht,
      und
   b3) mindestens einer Verbindung der oben angegebenen Formel (II), worin R⁶ die oben angegebenen allgemeinen und bevorzugten Bedeutungen hat,
      und die Menge an Me-Metallionen 100 Mol-% beträgt, bezogen auf ein Mol aller Metallionenim Addukt a3)/b3),
      miteinander vermischt, wobei pro Mol an Addukt a1)/b1) 0,005 bis 15 Mol an Addukt a2)/b2) eingesetzt werden und 0 bis 0,05 Mol an Addukt a3)/b3) eingesetzt werden bezogen auf die Summe der Molmenge an Addukt a1/)b1) und a2)/b2).

Bevorzugt ist die Herstellung binärer Adduktmischungen wobei pro Mol an Addukt a1)/b1) 0,05 bis 1 Mol an Addukt a2)/b2), vorzugsweise pro Mol an Addukt a1)/b1) 0,1 bis 0,5 Mol an Addukt a2)/b2) eingesetzt wird.

Die erfindungsgemäßen Metallazopigmente zeichnen sich durch besonders gute Dispergierbarkeit und eine hohe Farbstärke aus. Chroma und Transparenz sind hervorragend einstellbar.

Die erfindungsgemäßen Metallazopigmente eignen sich hervorragend für alle Pigmentanwendungszwecke, insbesondere auch in Form ihrer Pigmentpräparationen.

Ein weiterer Gegenstand der vorliegenden Erfindung sind Pigmentpräparationen enthaltend wenigstens ein erfindungsgemäßes Metallazopigment und wenigstens einen Hilfs- und/oder Zusatzstoff.

Als Hilfs- oder Zusatzstoffe kommen im allgemeinen alle für Pigmentpräparationen üblichen Zusätze in Frage, beispielsweise solche aus der Reihe der oberflächenaktiven Mittel wie Dispergiermittel, Tenside, Netzmittel, Emulgatoren, sowie solche aus der Reihe der Oberflächenbelegungsmittel, der Basen und Lösungsmittel. Prinzipiell richtet sich der Hilfs- oder Zusatzstoff nach der Art des Zielsystems. Ist das Zielsystem z.B. ein Lack oder eine Druckfarbe dann wird der Hilfs- oder Zusatzstoff so ausgewählt, dass eine möglichst hohe Kompatibilität mit dem Zielsystem erreicht wird.

Vorzugsweise enthalten die erfindungsgemäßen Pigmentpräparationen mindestens ein oberflächenaktives Mittel.

Unter oberflächenaktiven Mitteln im Rahmen der vorliegenden Erfindung werden insbesondere Dispergiermittel verstanden, die die Pigmentteilchen in ihrer feinen partikulären Form in wässrigen Medien stabilisieren. Unter fein partikulär wird vorzugsweise eine Feinverteilung von 0,001 bis 5 µm verstanden, insbesondere von 0,005 bis 1 µm, besonders bevorzugt von 0,005 bis 0,5 µm. Die erfindungsgemäßen Pigmentpräparation liegt vorzugsweise fein partikulär vor.

Geeignete oberflächenaktive Mittel sind beispielsweise anionischer, kationischer, amphoterer oder nichtionogener Natur.

Geeignete anionische oberflächenaktive Mittel (c) sind insbesondere Kondensationsprodukte von aromatischen Sulfonsäuren mit Formaldehyd, wie Kondensationsprodukte aus Formaldehyd und Alkylnaphthalinsulfonsäuren oder aus Formaldehyd, Naphthalinsulfonsäuren und/oder Benzolsulfonsäuren, Kondensationsprodukte aus gegebenenfalls substituiertem Phenol mit Formaldehyd und Natriumbisulfit. Geeignet sind außerdem oberflächenaktive Mittel aus der Gruppe der Sulfobernsteinsäureester sowie Alkylbenzolsulfonate. Außerdem ionisch modifizierte, insbesondere sulfatierte oder carboxilierte, alkoxylierte Fettsäurealkohole oder deren Salze. Als alkoxylierte Fettsäurealkohole werden insbesondere solche mit 5 bis 120, vorzugsweise 5 bis 60, insbesondere mit 5 bis 30 Mol Ethylenoxid versehene C₆-C₂₂-Fettsäurealkohole, die gesättigt oder ungesättigt sind, verstanden. Weiterhin kommen vor allem Ligninsulfonate in Betracht, z.B. solche, die nach dem Sulfit- oder Kraft-Verfahren gewonnen werden. Vorzugsweise handelt es sich um Produkte, die zum Teil hydrolysiert, oxidiert, propoxyliert, sulfoniert, sulfomethyliert oder desulfoniert und nach bekannten Verfahren fraktioniert werden, z.B. nach dem Molekulargewicht oder nach dem Sulfonierungsgrad. Auch Mischungen aus Sulfit- und Kraftligninsulfonaten sind gut wirksam. Besonders geeignet sind Ligninsulfonate mit einem durchschnittlichen Molekulargewicht zwischen 1 000 und 100 000 g/mol, einem Gehalt an aktivem Ligninsulfonat von mindestens 80 Gew.-% und vorzugsweise mit niedrigem Gehalt an mehrwertigen Kationen. Der Sulfonierungsgrad kann in weiten Grenzen variieren.

Als nichtionische oberflächenaktive Mittel kommen beispielsweise in Frage: Umsetzungsprodukte von Alkylenoxiden mit alkylierbaren Verbindungen, wie z.B. Fettalkoholen, Fettaminen, Fettsäuren, Phenolen, Alkylphenolen, Arylalkylphenolen, wie Styrol-Phenol-Kondensate, Carbonsäureamiden und Harzsäuren. Hierbei handelt es sich z.B. um Ethylenoxidaddukte aus der Klasse der Umsetzungsprodukte von Ethylenoxid mit:
1) gesättigten und/oder ungesättigten Fettalkoholen mit 6 bis 22 C-Atomen oder
2) Alkylphenolen mit 4 bis 12 C-Atomen im Alkylrest oder
3) gesättigten und/oder ungesättigten Fettaminen mit 14 bis 20 C-Atomen oder
4) gesättigten und/oder ungesättigten Fettsäuren mit 14 bis 20 C-Atomen oder
5) hydrierte und/oder unhydrierte Harzsäuren.

Als Ethylenoxid-Addukte kommen insbesondere die unter 1) bis 5) genannten alkylierbaren Verbindungen mit 5 bis 120, insbesondere 5 bis 100, insbesondere 5 bis 60, besonders bevorzugt 5 bis 30 Mol Ethylenoxid in Frage.

Als oberflächenaktive Mittel eignen sich ebenfalls die aus DE-A 19 712 486 oder aus DE-A 19 535 246 bekannten Ester des Alkoxylierungsproduktes der Formel (X), die der Formel (XI) entsprechen sowie diese gegebenenfalls in Mischung mit den zugrundeliegenden Verbindungen

der Formel (X). Das Alkoxylierungsprodukt eines Styrol-Phenol-Kondensats der Formel (X) ist wie nachfolgend definiert: 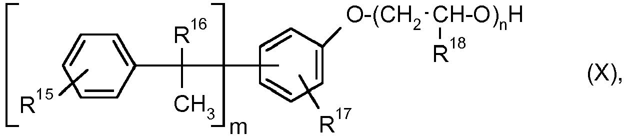 in der
- R¹⁵: Wasserstoff oder C₁-C₄-Alkyl bedeutet,
- R¹⁶: für Wasserstoff oder CH₃ steht,
- R¹⁷: Wasserstoff, C₁-C₄-Alkyl, C₁-C₄-Alkoxy, C₁-C₄-Alkoxycarbonyl oder Phenyl bedeutet,
- m: eine Zahl von 1 bis 4 bedeutet,
- n: eine Zahl von 6 bis 120 bedeutet,
- R¹⁸: für jede durch n indizierte Einheit gleich oder verschieden ist und für Wasserstoff, CH₃ oder Phenyl steht, wobei im Falle der Mitanwesenheit von CH₃ in den verschiedenen -(-CH₂-CH(R¹⁸)-O-)-Gruppen in 0 bis 60 % des Gesamtwertes von n R¹⁸ für CH₃ und in 100 bis 40 % des Gesamtwertes von n R¹⁸ für Wasserstoff steht und wobei im Falle der Mitanwesenheit von Phenyl in den verschiedenen -(-CH₂-CH(R¹⁸)-O-)-Gruppen in 0 bis 40 % des Gesamtwertes von n R¹⁸ für Phenyl und in 100 bis 60 % des Gesamtwertes von n R¹⁸ für Wasserstoff steht.

Die Ester der Alkoxylierungsprodukte (X) entsprechen der Formel (XI) 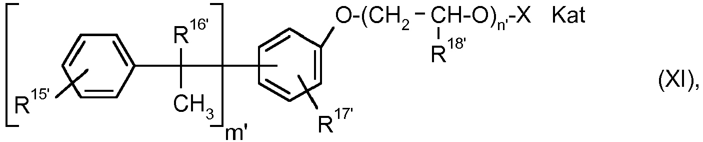 in der
- R^{15'}, R^{16'}, R^{17'}, R^{18'}, m' und n': den Bedeutungsumfang von R¹⁵, R¹⁶, R¹⁷, R¹⁸, m bzw. n, jedoch unabhängig hiervon, annehmen,
- X: die Gruppe -SO₃, -SO₂, -PO₃ oder -CO-(R¹⁹)-COO bedeutet,
- Kat: ein Kation aus der Gruppe von H, Li, Na, K, NH₄ oder HO-CH₂CH₂-NH₃ ist, wobei im Falle von X = -PO₃ zwei Kat vorliegen und
- R¹⁹: für einen zweiwertigen aliphatischen oder aromatischen Rest steht, vorzugsweise für C₁-C₄-Alkylen, insbesondere Ethylen, C₂-C₄- einfach ungesättigte Reste, insbesondere Acetylen oder gegebenenfalls substituiertes Phenylen, insbesondere ortho-Phenylen steht, wobei als mögliche Substituenten vorzugsweise C₁-C₄-Alkyl, C₁-C₄-Alkoxy, C₁-C₄-Alkoxycarbonyl oder Phenyl in Frage kommen.

Als ein bevorzugtes oberflächenaktive Mittel wird die Verbindung der Formel (XI) eingesetzt. Vorzugsweise eine Verbindung der Formel (XI), worin X einen Rest der Formel-CO-(R¹⁹)-COO⁻ bedeutet und R¹⁹ die obige Bedeutung besitzt.

Bevorzugt ist es ebenfalls als oberflächenaktive Mittel eine Verbindung der Formel (XI) zusammen mit einer Verbindung der Formel (X) einzusetzen. Vorzugsweise enthält das oberflächenaktive Mittel in diesem Fall 5 bis 99 Gew.-% der Verbindung (XI) und 1 bis 95 Gew.-% der Verbindung (X).

Das oberflächenaktive Mittel der Komponente (c) wird vorzugsweise in einer Menge von 0,1 bis 100 Gew.-%, insbesondere 0,5 bis 60 Gew.-%, bezogen auf das eingesetzte erfindungsgemäße Metallazopigment, in der Pigmentpräparation, verwendet.

Selbstverständlich kann die erfindungsgemäße Pigmentpräparation noch weitere Zusätze enthalten. So können beispielsweise die Viskosität einer wässrigen Suspension erniedrigende und/oder den Feststoffgehalt erhöhende Zusätze wie beispielsweise Carbonsäure- und Sulfonsäureamide in einer Menge von bis zu 10 Gew.-%, bezogen auf die Pigmentpräparation zugesetzt werden.

Weitere Zusätze sind beispielsweise anorganische und organische Basen sowie für Pigmentpräparation übliche Zusätze.

Als Basen sind zu nennen: Alkalihydroxide, wie beispielsweise NaOH, KOH oder organische Amine wie Alkylamine, insbesondere Alkanolamine oder Alkylalkanolamine.

Als besonders bevorzugt sind zu nennen Methylamin, Dimethylamin, Trimethylamin, Ethanolamin, n-Propanolamin, n-Butanolamin, Diethanolamin, Triethanolamin, Methylethanolamin oder Dimethylethanolamin.

Als Carbonsäure- und Sulfonsäureamide sind beispielsweise geeignet: Harnstoff und substituierte Harnstoffe wie Phenylharnstoff, Dodecylharnstoff und andere; Heterocyclen wie Barbitursäure, Benzimidazolon, Benzimidazolon-5-sulfonsäure, 2,3-Dihydroxychinoxalin, 2,3-Dihydroxychinoxalin-6-sulfonsäure, Carbazol, Carbazol-3,6-disulfonsäure, 2-Hydroxychinolin, 2,4-Dihydroxychinolin, Caprolactam, Melamin, 6-Phenyl-1,3,5-triazin-2,4-diamin, 6-Methyl-1,3,5-triazin-2,4-diamin, Cyanursäure.

Die Base ist gegebenenfalls bis zu einer Menge von 20 Gew.-%, vorzugsweise bis 10 Gew.-%, bezogen auf das Pigment enthalten.

Weiterhin können die erfindungsgemäßen Pigmentpräparationen herstellungsbedingt noch anorganische und/oder organische Salze enthalten.

Die erfindungsgemäßen Pigmentpräparationen sind vorzugsweise bei Raumtemperatur fest. Insbesondere liegen die erfindungsgemäßen Pigmentpräparationen als Pulver oder Granulate vor.

Die erfindungsgemäßen Pigmentpräparationen eignen sich hervorragend für alle Pigmentanwendungszwecke.

Weiterer Gegenstand der vorliegenden Erfindung ist die Verwendung mindestens eines erfindungsgemäßen Metallazopigments oder einer erfindungsgemäßen Pigmentpräparation zum Pigmentieren von Lacken aller Art für die Herstellung von Druckfarben, Leimfarben oder Binderfarben, für die Massefärbung von Papier, für die Massefärbung von synthetischen, halbsynthetischen oder natürlichen makromolekularen Stoffen, wie z.B. Polyvinylchlorid, Polystyrol, Polyamid, Polyethylen oder Polypropylen. Sie können auch für die Spinnfärbung von natürlichen, regenerierten oder künstlichen Fasern, wie z.B. Cellulose-, Polyester-, Polycarbonat-, Polyacrylnitril- oder Polyamidfasern, sowie zum Bedrucken von Textilien und Papier verwendet werden. Aus diesen Pigmenten können feinteilige, stabile, wässrige Pigmentierungen von Dispersions- und Anstrichfarben, die für die Papierfärbung, für den Pigmentdruck von Textilien, für den Laminatdruck oder für die Spinnfärbung von Viskose brauchbar sind, durch Mahlen oder Kneten in Gegenwart von nichtionogenen, anionischen oder kationischen Tensiden hergestellt werden.

Die erfindungsgemäßen Metallazopigmente eignen sich weiterhin hervorragend für Ink Jet Anwendungen und für Farbfilter für Flüssigkristallanzeigen.

In einer ebenfalls bevorzugten Ausführungsform enthalten die erfindungsgemäßen Pigmentpräparationen wenigstens eine organische Verbindung (d) ausgewählt aus der Gruppe der Terpene, Terpenoide, Fettsäuren, Fettsäureester und der Homo- oder Copolymere, wie statistische- oder Block-Copolymere mit einer Löslichkeit in pH neutralem Wasser bei 20°C von weniger als 1 g/l, insbesondere weniger als 0,1 g/l. Die organische Verbindung (d) ist vorzugsweise bei Raumtemperatur (20°C) unter Normalatmosphäre fest oder flüssig und weist im Falle, dass sie flüssig ist, einen Siedepunkt von vorzugsweise >100°C, insbesondere >150°C auf.

Bevorzugte Polymere besitzen sowohl einen hydrophilen wie auch einen hydrophoben vorzugsweise polymeren Molekülteil. Beispiele derartiger Polymere sind statistische Copolymere auf Basis von Fettsäuren oder langkettigen C₁₂-C₂₂-Kohlenwasserstoffen und Polyalkylenglykolen, insbesondere Polyethylenglykol. Ferner Block-Copolymere auf Basis von (Poly)Hydroxy Fettsäuren und Polyalkylenglykol, insbesondere Polyethylenglykol, sowie Pfropf-Copolymere auf Basis von Poly(meth)acrylat und Polyalkylenglykol, insbesondere Polyethylenglykol.

Als bevorzugte Verbindungen aus der Gruppe der Terpene, Terpenoide, Fettsäuren und Fettsäureester seien genannt: Ocimen, Myrcen, Geraniol, Nerol, Linalool, Citronellol, Geranial, Citronellal, Neral, Limonen, Menthol, beispielsweise (-)-Menthol, Menthon oder bicyclische Monoterpene, gesättigte und ungesättigte Fettsäuren mit 6 bis 22 C-Atomen, wie beispielsweise Ölsäure, Linolsäure und Linolensäure oder Mischungen davon.

Als organische Verbindungen der Komponente (d) kommen ferner auch die oben genannten Adduktbildner infrage soweit sie den für die Verbindung der Komponente (d) gewünschten Kriterien gehorchen.

Besonders bevorzugte Pigmentpräparationen enthalten:

| | |
|---|---|
| 50 - 99 Gew.-% | an wenigstens einem erfindungsgemäßen Metallazopigment und |
| 1 - 50 Gew.-% | vorzugsweise 2 bis 50 Gew.-% an wenigstens einer Verbindung der Komponente (d). |

Gegebenenfalls enthält die erfindungsgemäße Pigmentpräparation zusätzlich ein oberflächenaktives Mittel (c).

Besonders bevorzugt bestehen die erfindungsgemäßen Präparationen zu mehr als 90 Gew.-%, vorzugsweise mehr als 95 Gew.-% und insbesondere mehr als 97 Gew.-% aus mindestens einem erfindungsgemäßen Metallazopigment, mindestens einer organischen Verbindung der Komponente (d) und gegebenenfalls mindestens einem oberflächenaktiven Mittel der Komponente (c) und gegebenenfalls mindestens einer Base.

Die erfindungsgemäßen Pigmentpräparationen dieser Zusammensetzung eignen sich insbesondere zur Pigmentierung von Ink Jet Tinten und von Farbfiltern für Flüssigkristallanzeigen.

Ein weiterer Gegenstand der vorliegenden Erfindung ist ein Verfahren zur Herstellung der erfindungsgemäßen Pigmentpräparationen das dadurch gekennzeichnet ist, dass man mindestens ein erfindungsgemäßes Metallazopigment, und mindestens einen Hilfs- oder Zusatzstoff, insbesondere mindestens eine organischen Verbindung der Komponente (d) und gegebenenfalls mindestens ein oberflächenaktives Mittel der Komponente (c) und gegebenenfalls mindestens eine Base, miteinander vermischt.

Ebenfalls Gegenstand der vorliegenden Erfindung ist die Verwendung der erfindungsgemäßen Metallazopigmente oder der erfindungsgemäßen Pigmentpräparationen zur Herstellung von Farbfiltern für Flüssigkristallanzeigen. Im Folgenden sei diese Verwendung am Beispiel der Pigment-Dispersionsmethode nach dem Photolackverfahren beschrieben.

Die erfindungsgemäße Verwendung der erfindungsgemäßen Pigmentpräparationen zur Herstellung von Farbfiltern ist beispielsweise dadurch gekennzeichnet, dass mindestens ein erfindungsgemäßes Metallazopigment oder eine erfindungsgemäße Pigmentpräparation, insbesondere feste Pigmentpräparation, gegebenenfalls mit einem Bindemittelharz und einem organischen Lösungsmittel, gegebenenfalls unter Zusatz eines Dispergiermittels, homogenisiert und anschließend kontinuierlich oder diskontinuierlich auf eine Teilchengröße nach Anzahl (elektronenmikroskopische Bestimmung) von 99,5 % <1000 nm, vorzugsweise 95 % <500 nm und insbesondere 90 % <200 nm nasszerkleinert wird.

Als Nasszerkleinerungsverfahren kommen beispielsweise Rührer- oder Dissolverdispergierung, Mahlen mittels Rührwerkskugel- oder -perlmühlen, Kneter, Walzenstuhl, Hochdruckhomogenisierung oder Ultraschalldispergierung in Frage.

Während der Dispergierbehandlung oder im Anschluss daran erfolgt die Zugabe von mindestens einem photohärtbaren Monomeren und einem Photoinitiator. Im Anschluss an die Dispergierung kann noch weiteres Bindemittelharz, Lösungsmittel oder für Photolacke übliche Zuschlagstoffe eingebracht werden, wie es für die gewünschte photosensitive Beschichtungsmitteleinstellung (Photolack) zur Herstellung der Farbfilter erforderlich ist. Im Rahmen dieser Erfindung wird unter Photolack eine Präparation verstanden, die wenigstens ein photohärtbares Monomer und einen Photoinitiator enthält.

Gegenstand der vorliegenden Erfindung ist auch ein Verfahren zur Herstellung von Farbfiltern für Flüssigkristallanzeigen das dadurch gekennzeichnet ist, dass man mindestens ein erfindungsgemäßes Metallazopigment oder eine erfindungsgemäße Pigmentpräparation, gegebenenfalls mit einem Bindemittelharz und einem organischen Lösungsmittel, gegebenenfalls unter Zusatz eines Dispergiermittels, homogenisiert und anschließend kontinuierlich oder diskontinuierlich auf eine Teilchengröße nach Anzahl (elektronenmikroskopische Bestimmung) von 99,5% <1000 nm, nasszerkleinert und während der Dispergierbehandlung oder im Anschluss daran mindestens ein photohärtbares Monomer und einem Photoinitiator zugibt.

Als mögliche Dispergiermittel kommen allgemein handelsübliche, für diesen Anwendungszweck geeignete Dispergiermittel wie beispielsweise polymere, ionogene oder nicht-ionogene Dispergiermittel bspw. auf Basis von Polycarbonsäuren oder Polysulfonsäuren, sowie Polyethylenoxid-Polypropylenoxid-Block-Copolymere in Betracht.

Ferner können auch Derivate organischer Farbstoffe als Dispergiermittel oder Co-Dispergiermittel verwendet werden.

Bei der Herstellung der Farbfilter fallen daher "Zubereitungen" an, die bezogen auf die Zubereitung enthalten:
- wenigstens ein erfindungsgemäßes Metallazopigment,
- gegebenenfalls ein Bindemittelharz,
- wenigstens ein organisches Lösungsmittel sowie
- gegebenenfalls ein Dispergiermittel.

In einer bevorzugten Ausführungsform enthält die Zubereitung (Angaben bezogen auf Zubereitung):

| | |
|---|---|
| 1 - 50 Gew.-% | eines erfindungsgemäßen Metallazopigments |
| 0 - 20 Gew.-% | Bindemittelharz |
| 0 - 20 Gew.-% | Dispergiermittel |
| 10 - 94 Gew.-% | organisches Lösungsmittel |

Die Beschichtung des Photolackes auf eine Platte zur Erzeugung der gefärbten Bildelementmuster kann entweder durch direkten oder indirekten Auftrag geschehen. Als Auftragsmethoden seien bspw. genannt: Roller-Coating, Spin-Coating, Spray-Coating, Dip-Coating und Air-Knife-Coating.

Als Platten kommen je nach Verwendung beispielsweise in Frage: transparente Gläser wie weiße oder blaue Glasplatte, mit Silikat beschichtete blaue Glasplatte, Kunstharzplatte oder -filme auf Basis von z.B. Polyester-, Polycarbonat-, Acryl-, oder Vinylchloridharz, ferner Metallplatten auf Basis von Aluminium, Kupfer, Nickel, oder Stahl sowie Keramikplatten oder Halbleiterplatten mit aufgebrachten photoelektrischen Transferelementen.

Die Auftragung erfolgt im Allgemeinen so, dass die Schichtdicke der erhaltenen photosensitiven Schicht bei 0,1 bis 10 µm liegt.

Im Anschluss an den Auftrag kann eine thermische Trocknung der Schicht erfolgen.

Die Belichtung erfolgt vorzugsweise, indem die photosensitive Schicht einem aktiven Lichtstrahl vorzugsweise in Form eines Bildmusters mittels Photomaske ausgesetzt wird. Hierdurch wird an
den belichteten Stellen die Schicht gehärtet. Geeignete Lichtquellen sind z.B.: Hochdruck- und Ultrahochdruckquecksilberdampflampe, Xenon-, Metallhalogenid-, Fluoreszenzlampe sowie Laserstrahl im sichtbaren Bereich.

Durch die Entwicklung im Anschluss an die Belichtung wird der unbelichtete Teil der Beschichtung entfernt und man erhält die gewünschte Bildmusterform der Farbelemente. Übliche Entwicklungsmethoden umfassen das Besprühen mit oder Tauchen in wässrige alkalische Entwicklerlösung oder in ein organisches Lösungsmittel, das anorganische Alkali wie z.B. Natrium- oder Kaliumhydroxid, Natriummetasilikat oder organische Basen wie Monoethanolamin, Diethanolamin, Triethanolamin, Triethylamin oder deren Salze enthält.

Nach der Entwicklung erfolgt in der Regel eine thermische Nachtrocknung/-härtung der Bildmuster.

Die erfindungsgemäße Verwendung der Metallazopigmente ist vorzugsweise dadurch gekennzeichnet, dass diese alleine oder in Mischung mit anderen, für die Herstellung von Farbfiltern üblichen, Pigmenten in den Farbfiltern bzw. Pigmentpräparationen oder Zubereitungen für Farbfilter eingesetzt werden.

Diese "anderen Pigmente" können sowohl andere Metallsalze einer Azo-Verbindung der Formel (I) oder darauf basierende Pigmentpräparationen sein als auch andere anorganische oder organische Pigmente.

Hinsichtlich der Auswahl anderer gegebenenfalls mitzuverwendender Pigmente besteht erfindungsgemäß keine Einschränkung. Es kommen sowohl anorganische als auch organische Pigmente in Frage.

Bevorzugte organische Pigmente sind z.B. solche der Monoazo-, Disazo-, verlackte Azo-, β-Naphthol-, Napthol AS-, Benzimidazolon-, Disazokondensations-, Azometallkomplex-, Isoindolin- und Isoindolinon-Reihe, ferner polycyclische Pigmente wie z.B. aus der Phthalocyanin-, Chinacridon-, Perylen-, Perinon-, Thioindigo-, Anthrachinon-, Dioxazin-, Chinophthalon- und Diketopyrrolopyrrol-Reihe. Außerdem verlackte Farbstoffe wie Ca-, Mg- und Al-Lacke von sulfonsäure- oder carbonsäuregruppenhaltigen Farbstoffen.

Beispiele für gegebenenfalls mitzuverwendende andere organische Pigmente sind:
Colour Index Pigment Yellow 12, 13, 14, 17, 20, 24, 74, 83, 86, 93, 94, 109, 110, 117, 125, 137, 138, 139, 147, 148, 150, 153, 154, 166, 173, 185, oder
Colour Index Pigment Orange 13, 31, 36, 38, 40, 42, 43, 51, 55, 59, 61, 64, 65, 71, 72, 73 oder
Colour Index Pigment Red 9, 97, 122, 123, 144, 149, 166, 168, 177, 180, 192, 215, 216, 224, 254, 272, oder
Colour Index Pigment Green 7, 10, 36, 37, 45, 58 oder
Colour Index Pigment Blue 15, 15:1, 15:2, 15:3, 15:4, 15:6, 16 sowie
Colour Index Pigment Violett 19, 23.

Darüber hinaus können auch lösliche organische Farbstoffe in Verbindung mit den erfindungsgemäßen neuen Pigmenten eingesetzt werden.

Sofern "andere Pigmente" zusätzlich eingesetzt werden, beträgt der Anteil an erfindungsgemäßem Metallazopigment vorzugsweise 1-99 Gew.-%, insbesondere 20-80 Gew.-% bezogen auf die eingesetzte Gesamtmenge aller Pigmente. Besonders bevorzugt sind die erfindungsgemäßen Pigmentpräparationen sowie Zubereitungen, enthaltend mindestens ein erfindungsgemäßes Metallazopigment und C.I. Pigment Green 36 und/oder C.I. Pigment Green 58 im Verhältnis von 20 bis 80 Gew.-% Metallazopigment zu 80 bis 20 Gew.-% C.I. Pigment Green 36 und/oder C.I. Pigment Green 58, vorzugsweise von 40 bis 60 Gew.- % zu 60 bis 40 Gew.-%.

Hinsichtlich der Bindemittelharze, die zusammen mit dem "Pigment" oder darauf basierender Pigmentpräparationen in Farbfiltern bzw. in den Zubereitungen zur Herstellung von Farbfiltern z.B. nach der Pigment-Dispersionsmethode eingesetzt werden können, besteht erfindungsgemäß keine besondere Einschränkung, insbesondere kommen für die Anwendung in Farbfiltern an sich bekannte filmbildende Harze in Frage.

Beispielsweise kommen Bindemittelharze aus der Gruppe der Celluloseharze wie Carboxymethylhydroxyethylcellulose und Hydroxyethylcellulose, Acrylharze, Alkydharze, Melaminharze, Epoxidharze, Polyvinylalkohole, Polyvinylpyrrolidone, Polyamide, Polyamidimine, Polyimide,

Polyimidvorstufen wie solche der Formel (14), offenbart in JP-A 11 217 514 und deren Veresterungsprodukte in Frage.

Als solche sind beispielsweise Umsetzungsprodukte von Tetracarbonsäuredianhydrid mit Diaminen zu nennen.

Als Bindemittelharze kommen auch solche in Frage, die photopolymerisierbare, ungesättigte Bindungen enthalten. Die Bindemittelharze können beispielsweise solche aus der Gruppe der Acrylharze aufgebaut sein. Dabei sind insbesondere Homo- und Copolymere polymerisierbarer Monomere zu nennen wie z.B. (Meth)acrylsäuremethylester, (Meth)acrylsäureethylester, (Meth)acrylsäurepropylester, (Meth)acrylsäurebutylester, Styrol und Styrolderivate, ferner Copolymere zwischen carboxylgruppentragenden polymerisierbaren Monomeren wie (Meth)acrylsäure, Itaconsäure, Maleinsäure, Maleinsäureanhydrid, Maleinsäuremonoalkylester, insbesondere mit Alkyl von 1 bis 12 C-Atomen, und polymerisierbare Monomere wie (Meth)acrylsäure, Styrol und Styrolderi-vate, wie z.B. α-Methylstyrol, m- oder p-Methoxystyrol, p-Hydroxystyrol. Als Beispiele seien genannt Umsetzungsprodukte von carboxylgruppenhaltigen polymeren Verbindungen mit Verbindungen, die jeweils einen Oxiranring und eine ethylenisch ungesättigte Verbindung enthalten wie z.B. Glycidyl(meth)acrylat, Acrylglycidylether und Itaconsäuremonoalkylglycidylether usw., ferner Umsetzungsprodukte von carboxylgruppenhaltigen polymeren Verbindungen mit Verbindungen, die jeweils eine Hydroxylgruppe und eine ethylenisch ungesättigte Verbindung (ungesättigte Alkohole) enthalten wie Allylalkohol, 2-Buten-4-ol, Oleylalkohol, 2-Hydroxyethyl-(meth)acrylat, N-Methylolacrylamid usw.;

weiterhin können derartige Bindemittelharze auch ungesättigte Verbindungen, die freie Isocyanatgruppen besitzen, enthalten.

Im Allgemeinen liegt die Äquivalenz der Ungesättigtheit (Molgewicht Bindemittelharz pro ungesättigte Verbindung) der genannten Bindemittelharze bei 200 bis 3 000, insbesondere 230 bis 1 000, um sowohl eine ausreichende Photopolymerisierbarkeit und Härte des Films zu erreichen. Der Säurewert liegt im Allgemeinen bei 20 bis 300, insbesondere 40 bis 200, um eine genügende Alkali-Entwicklungsfähigkeit nach der Belichtung des Films zu erzielen.

Das mittlere Molgewicht der einzusetzenden Bindemittelharze liegt zwischen 1 500 und 200 000, insbesondere 10 000 bis 50 000 g/mol.

Die bei der erfindungsgemäßen Verwendung der Pigmentpräparationen für Farbfilter eingesetzten organischen Lösungsmittel sind z.B. Ketone, Alkylenglykolether, Alkohole und aromatische Verbindungen. Beispiele aus der Gruppe der Ketone sind: Aceton, Methylethylketon, Cyclohexanon etc.; aus der Gruppe der Alkylenglykolether: Methylcellosolve (Ethylenglykolmonomethylether), Butylcellosolve (Etylenglykolmonobutylether) Methylcellosolveacetat, Ethylcellosolveacetat, Butylcellosolveacetat, Ethylenglykolmonopropylether, Ethylenglykolmonohexylether, Ethylenglykoldimethylether, Diethylenglykolethylether, Diethylenglykoldiethylether, Propylenglykolmonomethylether, Propylenglykolmonoethylether, Propylenglykolmonopropylether, Propylenglykolmonobutylether, Propylenglykolmonomethyletheracetat, Diethylenglykolmethyletheracetat, Diethylenglykolethyletheracetat, Diethylenglykolpropyletheracetat, Diethylenglykolisopropyletheracetat, Diethylenglykolbutyletheracetat, Diethylenglykol-t-butyletheracetat, Triethylenglykolmethyletheracetat, Triethylenglykolethyletheracetat, Triethylenglykolpropyletheracetat, Triethylenglykolisopropyletheracetat, Triethylenglykolbutyletheracetat, Triethylenglykol-t-butyletheracetat, etc.; aus der Gruppe der Alkohole: Methylalkohol, Ethylalkohol, Isopropylalkohol, n-Butylalkohol, 3-Methyl-3-methoxybutanol, etc.; aus der Gruppe der aromatischen Lösungsmittel Benzol, Toluol, Xylol, N-Methyl-2-Pyrrolidon, N-Hydroxymethyl-2-Essigsäureethylester, etc.

Weitere andere Lösungsmittel sind 1,2-Propandioldiacetat, 3-Methyl-3-methoxy-butylacetat, Essigsäureethylester, Tetrahydrofuran, etc. Die Lösungsmittel können einzeln oder in Gemischen untereinander eingesetzt werden.

Die Erfindung betrifft weiterhin einen Photolack, enthaltend wenigstens ein erfindungsgemäßes Metallazopigment oder wenigstens eine erfindungsgemäße Pigmentpräparation und wenigstens ein photohärtbares Monomer sowie wenigstens einen Photoinitiator.

Die photohärtbaren Monomere enthalten im Molekül wenigstens eine reaktive Doppelbindung und gegebenenfalls andere reaktive Gruppen.

Als photohärtbare Monomere seien in diesem Zusammenhang insbesondere reaktive Lösungsmittel bzw. sog. Reaktivverdünner verstanden z.B. aus der Gruppe der mono-, di- , tri- und multifunktionelle Acrylate und Methacrylate, Vinylether, sowie Glycidylether. Als zusätzlich enthaltene reaktive Gruppen kommen in Frage Allyl-, Hydroxy-, Phosphat-, Urethan-, sek. Amin- und N-Alkoxymethylgruppen.

Derartige Monomere sind dem Fachmann bekannt und beispielsweise in *[*Römpp Lexikon, Lacke und Druckfarben, Dr. Ulrich Zorll, Thieme Verlag Stuttgart-New York, 1998, S. 491/492*]* aufgeführt.

Die Auswahl der Monomere richtet sich insbesondere nach der Art und Intensität der verwendeten Strahlenart der Belichtung, der gewünschten Reaktion mit dem Photoinitiator und den Filmeigenschaften. Es können auch Kombinationen von Monomeren eingesetzt werden.

Als Photoreaktionsstarter oder Photoinitiatoren seien Verbindungen verstanden, die infolge der Absorption sichtbarer oder ultravioletter Strahlung reaktive Zwischenprodukte bilden, die eine Polymerisationsreaktion beispielsweise der oben genannten Monomeren und/oder Bindemittelharze auslösen können. Photoreaktionsstarter sind ebenfalls allgemein bekannt und können ebenfalls aus *[*Römpp Lexikon, Lacke und Druckfarben, Dr. Ulrich Zorll, Thieme Verlag Stuttgart-New York, 1998, S. 445/446*]* entnommen werden.

Erfindungsgemäß besteht keine Einschränkung hinsichtlich der einzusetzenden photohärtbaren Monomeren oder Photoinitiatoren.

Die Erfindung betrifft bevorzugt Photolacke enthaltend
A) wenigstens ein erfindungsgemäßes Metallazopigment, insbesondere in Mischung mit anderen Pigmenten, vorzugsweise C.I. Pigment Green 36 und/oder Pigment Green 58 oder eine darauf basierende erfindungsgemäße Pigmentpräparation,
B1) wenigstens ein photohärtbares Monomer,
B2) wenigstens einen Photoinitiator,
C1) gegebenenfalls ein organisches Lösungsmittel,
D) gegebenenfalls ein Dispergiermittel,
E) gegebenenfalls ein Bindemittelharz,
sowie gegebenenfalls weitere Zusätze.

Erfindungsgemäß besteht auch keine Einschränkung hinsichtlich der Technologie zur Erzeugung der gefärbten Bildelementmuster auf Basis der erfindungsgemäß zu verwendenden Pigmente oder feste Pigmentpräparationen. Neben dem oben beschriebenen photolithographischen Verfahren sind andere Verfahren wie Offset-Druck, chemisches Ätzen oder Ink Jet Druck ebenso geeignet. Die Auswahl der geeigneten Bindemittelharze und Lösungsmittel bzw. Pigment-Trägermedien sowie weitere Zusätze sind auf das jeweilige Verfahren abzustimmen. Beim Ink Jet Verfahren, worunter sowohl der thermische als auch mechanische und piezo-mechanische Ink Jet Druck verstanden werden, kommen neben rein organischen auch wässrig-organische Trägermedien für die Pigmente und gegebenenfalls Bindemittelharze in Frage, wässrig-organische Trägermedien werden sogar bevorzugt.

Die folgenden Beispiele sollen die vorliegende Erfindung erläutern ohne sie jedoch darauf zu beschränken.

### Beispiele

### Herstellung der Vorstufe Azobarbitursäure (Vorschrift 1)

In 1100 g destillierten Wasser von 85°C wurden 46,2 g Diazobarbitursäure und 38,4 g Barbitursäure eingetragen. Anschließend wurde mit wässriger Kalilauge ein pH-Wert von etwa 5 eingestellt und 90 Minuten nachgerührt.

### Beispiel 1: Herstellung von Pigment A

Eine nach Vorschrift 1 hergestellte Azobarbitursäure wurde bei 82°C mit 1500 g destilliertem Wasser versetzt. Danach wurden 75,7 g Melamin eingetragen. Anschließend wurden 0,3 Mol einer ca. 30-%igen Kupfer(II)chlorid-Lösung zugetropft. Nach 3 Stunden bei 82°C wurde mit KOH auf einen pH-Wert von ca. 5,5 eingestellt. Danach wurde bei 90°C mit ca. 300 g destilliertem Wasser verdünnt. Anschließend wurden 34 g 30-%ige Salzsäure zugetropft und 12 Stunden bei 90°C getempert. Danach wurde mit wässriger Kalilauge ein pH-Wert von ca. 5 eingestellt. Anschließend wurde das Pigment auf einer Saugnutsche isoliert, gewaschen und bei 80°C im Vakuumtrockenschrank getrocknet und in einer üblichen Labormühle ca. 2 Minuten gemahlen. (= Pigment A)

### Beispiel 2: Herstellung von Pigment B

Eine nach Vorschrift 1 hergestellte Azobarbitursäure wurde bei 82°C mit 1500 g destilliertem Wasser versetzt. Anschließend wurden 10 g 30-%ige Salzsäure zugetropft. Danach wurden 79,4 g Melamin eingetragen. Anschließend wurden 0,3 Mol einer ca. 25-%igen Zinkchlorid-Lösung zugetropft. Nach 3 Stunden bei 82°C wurde mit KOH auf einen pH-Wert von ca. 5,5 eingestellt. Danach wurde bei 90°C mit ca. 100 g destilliertem Wasser verdünnt. Anschließend wurden 21 g 30-%ige Salzsäure zugetropft und 12 Stunden bei 90°C getempert. Danach wurde mit wässriger Kalilauge auf einen pH-Wert von ca. 5 eingestellt. Anschließend wurde das Pigment auf einer Saugnutsche isoliert, gewaschen und bei 80°C im Vakuumtrockenschrank getrocknet und in einer üblichen Labormühle ca. 2 Minuten gemahlen. (= Pigment B)

### Beispiele 3 bis 15: Herstellung der Pigmente C bis O

Die nachfolgenden erfindungsgemäßen Beispiele 3 bis 15 wurden analog zu Beispiel 2 hergestellt. Dabei wurde die Zinkchlorid-Lösung jeweils durch eine Mischlösung aus Zinkchlorid und Kupfer(II)chlorid wie angegeben ersetzt.
**Beispiel 3:** 0,3 Mol Zn ersetzt durch 0,282 Mol Zn + 0,0015 Mol Cu (= Pigment C)
**Beispiel 4:** 0,3 Mol Zn ersetzt durch 0,282 Mol Zn + 0,006 Mol Cu (= Pigment D)
**Beispiel 5:** 0,3 Mol Zn ersetzt durch 0,282 Mol Zn + 0,018 Mol Cu (= Pigment E)
**Beispiel 6:** 0,3 Mol Zn ersetzt durch 0,270 Mol Zn + 0,030 Mol Cu (= Pigment F)
**Beispiel 7:** 0,3 Mol Zn ersetzt durch 0,240 Mol Zn + 0,060 Mol Cu (= Pigment G)
**Beispiel 8:** 0,3 Mol Zn ersetzt durch 0,210 Mol Zn + 0,090 Mol Cu (= Pigment H)
**Beispiel 9:** 0,3 Mol Zn ersetzt durch 0,180 Mol Zn + 0,120 Mol Cu (= Pigment I)
**Beispiel 10:** 0,3 Mol Zn ersetzt durch 0,150 Mol Zn + 0,150 Mol Cu (= Pigment J)
**Beispiel 11:** 0,3 Mol Zn ersetzt durch 0,120 Mol Zn + 0,120 Mol Cu (= Pigment K)
**Beispiel 12:** 0,3 Mol Zn ersetzt durch 0,090 Mol Zn + 0,210 Mol Cu (= Pigment L)
**Beispiel 13:** 0,3 Mol Zn ersetzt durch 0,060 Mol Zn + 0,240 Mol Cu (= Pigment M)
**Beispiel 14:** 0,3 Mol Zn ersetzt durch 0,030 Mol Zn + 0,270 Mol Cu (= Pigment N)
**Beispiel 15:** 0,3 Mol Zn ersetzt durch 0,018 Mol Zn + 0,282 Mol Cu (= Pigment O)
**Beispiel 16:** 0,3 Mol Zn ersetzt durch 0,270 Mol Zn + 0,015 Mol Cu + 0,015 Mol Ni (= Pigment AA)
**Beispiel 17:** 0,3 Mol Zn ersetzt durch 0,270 Mol Zn + 0,015 Mol Cu + 0,015 Mol Cd (= Pigment AB)
**Beispiel 18:** 0,3 Mol Zn ersetzt durch 0,270 Mol Zn + 0,015 Mol Cu + 0,0075 Mol Fe + 0,0075 Mol Pb (= Pigment AC)
**Beispiel 19:** 0,3 Mol Zn ersetzt durch 0,270 Mol Zn + 0,015 Mol Cu + 0,006 Mol Ni + 0,004 Mol Cr + 0,003 Mol Fe (= Pigment AD)
**Beispiel 20:** 0,3 Mol Zn ersetzt durch 0,150 Mol Zn + 0,135 Mol Cu + 0,015 Mol Cd (= Pigment AE)
**Beispiel 21:** 0,3 Mol Zn ersetzt durch 0,150 Mol Zn + 0,135 Mol Cu + 0,010 Mol Cr (= Pigment AF)
**Beispiel 22:** 0,3 Mol Zn ersetzt durch 0,150 Mol Zn + 0,135 Mol Cu + 0,0075 Mol Co + 0,0075 Mol Pb (= Pigment AG)
**Beispiel 23:** 0,3 Mol Zn ersetzt durch 0,150 Mol Zn + 0,135 Mol Cu + 0,006 Mol Ni + 0,006 Mol Pb + 0,003 Mol Cd (= Pigment AH)
**Beispiel 24:** 0,3 Mol Zn ersetzt durch 0,015 Mol Zn + 0,270 Mol Cu + 0,015 Mol Fe (= Pigment Al)
**Beispiel 25:** 0,3 Mol Zn ersetzt durch 0,015 Mol Zn + 0,270 Mol Cu + 0,015 Mol Cd (= Pigment AJ)
**Beispiel 26:** 0,3 Mol Zn ersetzt durch 0,015 Mol Zn + 0,270 Mol Cu + 0,0075 Mol Ni + 0,0075 Mol Co (= Pigment AK)
**Beispiel 27:** 0,3 Mol Zn ersetzt durch 0,015 Mol Zn + 0,270 Mol Cu + 0,004 Mol Cr + 0,006 Mol Pb + 0,003 Mol Ni (= Pigment AL)
**Beispiel 28:** 0,3 Mol Zn ersetzt durch 0,273 Mol Zn + 0,015 Mol Cu + 0,012 Mol Ni (= Pigment AM)
**Beispiel 29:** 0,3 Mol Zn ersetzt durch 0,273 Mol Zn + 0,015 Mol Cu + 0,012 Mol Co (= Pigment AN)
**Beispiel 30:** 0,3 Mol Zn ersetzt durch 0,273 Mol Zn + 0,015 Mol Cu + 0,004 Mol Cr + 0,006 Mol Cd (= Pigment AO)
**Beispiel 30:** 0,3 Mol Zn ersetzt durch 0,273 Mol Zn + 0,015 Mol Cu + 0,0045 Mol Cd + 0,0045 Mol Pb + 0,003 Mol Fe (= Pigment AP)

**Aus den nach den Synthesebeispielen 1 bis 30 hergestellten Pigmenten wurden gemäß der Tabelle 1 folgende Proben zusammengestellt.**

**Tabelle 1**

| | | | Molverhältnis Cu / Zn / Me |
|---|---|---|---|
| **Probe 1:** | 10 g Pigment A | | 100 / 0 / 0 |
| **Probe 2:** | 10 g Pigment B | | 0 / 100 / 0 |
| **Probe 3:** | 10 g Pigment C | | 0,5 / 99,5 / 0 |
| **Probe 4:** | 10 g Pigment D | | 2 / 98 / 0 |
| **Probe 5:** | 10 g Pigment E | | 6 / 94 / 0 |
| **Probe 6:** | 10 g Pigment F | | 10 / 90 / 0 |
| **Probe 7:** | 10 g Pigment G | | 20 / 80 / 0 |
| **Probe 8:** | 10 g Pigment H | | 30 / 70 / 0 |
| **Probe 9:** | 10 g Pigment I | | 40 / 60 / 0 |
| **Probe 10:** | 10 g Pigment J | | 50 / 50 / 0 |
| **Probe 11:** | 10 g Pigment K | | 60 / 40 / 0 |
| **Probe 12:** | 10 g Pigment L | | 70 / 30 / 0 |
| **Probe 13:** | 10 g Pigment M | | 80 / 20 / 0 |
| **Probe 14:** | 10 g Pigment N | | 90 / 10 / 0 |
| **Probe 15:** | 10 g Pigment O | | 94 / 6 / 0 |
| **Probe 16:** | 0,05 g Pigment A | 9,95 g Pigment B | 0,5 / 99,5 / 0 |
| **Probe 17:** | 0,2 g Pigment A | 9,80 g Pigment B | 2 / 98 / 0 |
| **Probe 18:** | 0,6 g Pigment A | 9,40 g Pigment B | 6 / 94 / 0 |
| **Probe 19:** | 1,00 g Pigment A | 9,00 g Pigment B | 10 / 90 / 0 |
| **Probe 20:** | 2,00 g Pigment A | 8,00 g Pigment B | 20 / 80 / 0 |
| **Probe 21:** | 3,00 g Pigment A | 7,00 g Pigment B | 30 / 70 / 0 |
| **Probe 22:** | 4,00 g Pigment A | 6,00 g Pigment B | 40 / 60 / 0 |
| **Probe 23:** | 5,00 g Pigment A | 5,00 g Pigment B | 50 / 50 / 0 |
| **Probe 24:** | 6,00 g Pigment A | 4,00 g Pigment B | 60 / 40 / 0 |
| **Probe 25:** | 7,00 g Pigment A | 3,00 g Pigment B | 70 / 30 / 0 |
| **Probe 26:** | 8,00 g Pigment A | 2,00 g Pigment B | 80 / 20 / 0 |
| **Probe 27:** | 9,00 g Pigment A | 1,00 g Pigment B | 90 / 10 / 0 |
| **Probe 28:** | 9,40 g Pigment A | 0,06 g Pigment B | 94 / 6 / 0 |
| **Probe 29:** | 10 g Pigment AA | | 5 / 90 / 5 Ni |
| **Probe 30:** | 10 g Pigment AB | | 5 / 90 / 5 Cd |
| **Probe 31:** | 10 g Pigment AC | | 5 / 90 / 2,5 Fe / 2,5 Pb |
| **Probe 32:** | 10 g Pigment AD | | 5 / 90 / 2 Ni / 2Cr / 1 Fe |
| **Probe 33:** | 10 g Pigment AE | | 45 / 50 / 5 Cd |
| **Probe 34:** | 10 g Pigment AF | | 45 / 50 / 5 Cr |
| **Probe 35:** | 10 g Pigment AG | | 45 / 50 / 2,5 Co / 2,5 Pb |
| **Probe 36:** | 10 g Pigment AH | | 45 / 50 / 2 Ni / 2 Fe / 1 Cd |
| **Probe 37:** | 10 g Pigment Al | | 90 / 5 / 5 Fe |
| **Probe 38:** | 10 g Pigment AJ | | 90 / 5 / 5 Cd |
| **Probe 39:** | 10 g Pigment AK | | 90 / 5 / 2,5 Ni / 2,5 Co |
| **Probe 40:** | 10 g Pigment AL | | 90 / 5 / 2Cr / 2Pb / 1Ni |
| **Probe 41:** | 10 g Pigment AM | | 5 / 91 / 4 Ni |
| **Probe 42:** | 10 g Pigment AN | | 5 / 91 / 4Co |
| **Probe 43:** | 10 g Pigment AO | | 5 / 91 / 2Cr / 2 Cd |
| **Probe 44:** | 10 g Pigment AP | | 5 / 91 / 1,5 Cd / 1,5 Pb / 1 Fe |

Die Proben 1 bis 44 wurden jeweils einer Bestimmung der Dispergierhärte sowie einer Bestimmung der Farbstärke nach den im folgenden beschriebenen Methoden unterzogen. Die Ergebnisse sind in Tabelle 2 aufgeführt.

### Bestimmung der Dispergierhärte

Die Dispergierhärte wird gemessen nach DIN 53 775, Teil 7, wobei die Temperatur der Kaltwalzung 25°C und die der Warmwalzung 150°C beträgt. Sämtliche in dieser Anmeldung angegebenen Dispergierhärten wurden nach dieser modifizierten D IN -Vorschrift bestimmt.

### Bestimmung der Farbstärke in PVC

Als Prüfmedium wurde ein Weich-PVC-Compound, durch Homogenisierung von 67,5% Vestolit® E7004 (Vestolit GmbH), 29,0% Hexamoll® Dinch (BASF), 2,25% Baerostab UBZ 770 (Baerlocher GmbH) und 1,25% Isocolor Pigmentpaste weiß (ISL-Chemie) mit einem Labordissolver hergestellt.

Auf einem Laborwalzwerk wurden 100 g des PVC -Compounds bei 150°C auf zwei mit 20 min⁻¹ und 18 min⁻¹ rotierenden Walzen von 150 mm Durchmesser gegeben. Zusammen mit 0,10 g Pigment wurde das entstandene Walzfell achtmal durch einen Walzenspalt von 0,10 mm geführt. Dann wurde das gleichmäßig gefärbte Walzfell bei 0,8 mm Walzenspalt abgenommen und glatt auf eine Metallfläche abgelegt. Das abgekühlte Walzfell wurde dann auf zwei unbeheizten mit 26 min⁻¹ und 24 min⁻¹ rotierenden Walzen von 110 mm Durchmesser achtmal durch einen Waltenspalt von 0,2mm gegeben. Zur Glättung der Oberfläche wurde dieses Walzfell nochmals auf die Walzen von 150°C gegeben, bei 0,8 mm abgenommen und auf glatter Fläche abkühlen gelassen. Muster dieses Fells dienten zur Bestimmung der relativen Farbstärke.

Die Berechnung der relativen Farbstärke erfolgte nach Remissionsmessung der Muster vor einem Weißhintergrund mittels Spektralphotometer mit Messgeometrie d/8 unter Normlichtart D65 und 10° Beobachter nach DIN 55986 unter Verwendung der Summe der K/S-Werte über das sichtbare Spektrum (400nm-700nm).

**Tabelle 2:**

| | Status | Dispergierhärte | Farbstärke % |
|---|---|---|---|
| **Probe 1:** | nicht erfindungsgemäß | **350** | **80** |
| **Probe 2:** | nicht erfindungsgemäß | **450** | **30** |
| **Probe 3:** | erfindungsgemäß | **140** | **100** |
| **Probe 4:** | erfindungsgemäß | **135** | **102** |
| **Probe 5:** | erfindungsgemäß | **110** | **103** |
| **Probe 6:** | erfindungsgemäß | **105** | **105** |
| **Probe 7:** | erfindungsgemäß | **100** | **107** |
| **Probe 8:** | erfindungsgemäß | **110** | **110** |
| **Probe 9:** | erfindungsgemäß | **95** | **112** |
| **Probe 10:** | erfindungsgemäß | **90** | **113** |
| **Probe 11:** | erfindungsgemäß | **95** | **110** |
| **Probe 12:** | erfindungsgemäß | **90** | **115** |
| **Probe 13:** | erfindungsgemäß | **85** | **114** |
| **Probe 14:** | erfindungsgemäß | **80** | **119** |
| **Probe 15:** | erfindungsgemäß | **80** | **120** |
| **Probe 16:** | erfindungsgemäß | **160** | **98** |
| **Probe 17:** | erfindungsgemäß | **140** | **100** |
| **Probe 18:** | erfindungsgemäß | **115** | **103** |
| **Probe 19:** | erfindungsgemäß | **110** | **103** |
| **Probe 20:** | erfindungsgemäß | **105** | **105** |
| **Probe 21:** | erfindungsgemäß | **115** | **106** |
| **Probe 22:** | erfindungsgemäß | **100** | **105** |
| **Probe 23:** | erfindungsgemäß | **95** | **109** |
| **Probe 24:** | erfindungsgemäß | **100** | **109** |
| **Probe 25:** | erfindungsgemäß | **95** | **111** |
| **Probe 26:** | erfindungsgemäß | **90** | **112** |
| **Probe 27:** | erfindungsgemäß | **90** | **114** |
| **Probe 28:** | erfindungsgemäß | **85** | **115** |
| **Probe 29:** | erfindungsgemäß | **115** | **107** |
| **Probe 30:** | erfindungsgemäß | **120** | **109** |
| **Probe 31:** | erfindungsgemäß | **110** | **108** |
| **Probe 32:** | erfindungsgemäß | **112** | **110** |
| **Probe 33:** | erfindungsgemäß | **90** | **112** |
| **Probe 34:** | erfindungsgemäß | **95** | **115** |
| **Probe 35:** | erfindungsgemäß | **95** | **114** |
| **Probe 36:** | erfindungsgemäß | **90** | **115** |
| **Probe 37:** | erfindungsgemäß | **75** | **118** |
| **Probe 38:** | erfindungsgemäß | **80** | **119** |
| **Probe 39:** | erfindungsgemäß | **85** | **116** |
| **Probe 40:** | erfindungsgemäß | **75** | **120** |
| **Probe 41:** | erfindungsgemäß | **115** | **107** |
| **Probe 42:** | erfindungsgemäß | **110** | **108** |
| **Probe 43:** | erfindungsgemäß | **120** | **106** |
| **Probe 44:** | erfindungsgemäß | **115** | **109** |

Fazit: Aus Tabelle 2 ist ersichtlich, dass die nicht erfindungsgemäßen Proben alle eine Dispergierhärte über 100 aufweisen und damit deutlich höher liegen als die erfindungsgemäßen Proben. Daraus folgt, dass die nicht erfindungsgemäßen Proben schwerer dispergierbar und schlechter verarbeitbar sind als die erfindungsgemäßen Proben.

Darüber hinaus weisen alle erfindungsgemäßen Proben erhöhte Farbstärken auf. Dies bedeutet, dass diese Proben bezogen auf gleiche Einwaagen höhere optischen Dichten erreichen als die nicht erfindungsgemäßen Proben.

### Röntgendiffraktometrische Untersuchung

Die röntgendiffraktometrischen Messungen wurden in einem Theta/Theta-Reflexionsdiffraktometer vom Typ PANalytical EMPYREAN mit PIXcel-Detektor durchgeführt, das zur Identifizierung kristalliner Phasen geeignet ist.

**Geräteeinstellungen:**

| | |
|---|---|
| Diffraktometer System | EMPYREAN |
| Messprogramm | Scan 5-40 Standard_Reflexion VB, 17 mm bestrahlte Länge, 15mm Maske |
| Startposition [°2Th.] | 5 |
| Endposition [°2Th.] | 40 |
| Schrittweite [°2Th.] | 0,0130 |
| Schrittzeit [s] | 48,2 |
| Scan Modus | Continuous |
| OED Betriebsart | Scanning |
| OED Länge [°2Th.] | 3,35 |
| Art der Divergenzblende | Automatisch |
| Bestrahlte Länge [mm] | 17,00 |
| Probenlänge [mm] | 10,00 |
| Anodenmaterial | Cu |
| K-Alpha1 [Å] | 1,54060 |
| K-Alpha2 [Å] | 1,54443 |
| K-Beta [Å] | 1,39225 |
| K-A2 / K-A1 Verhältnis | 0,50000 |
| Filter | Nickel |
| Generatoreinstellung | 40 mA, 40 kV |
| Goniometer Radius [mm] | 240,00 |
| Abstand Focus-Div.blende [mm] | 100,00 |
| Primärstrahl-Monochromator | Kein |
| Probendrehung | Ja |

### Durchführung:

Die Proben der Beispiele 1 bis 28 wie in Tabelle 1 beschrieben wurden wie folgt untersucht:
Für die Theta/Theta- Messungen wurde jeweils eine Menge der zu prüfenden Probe in die Vertiefung des Probenhalters eingebracht. Die Oberfläche der Probe wurde mittels eins Schabers geglättet.

Dann wurde der Probenhalter in den Probenwechsler des Diffraktometers eingebracht und die Messung durchgeführt. Die Theta-Werte der gemessenen Proben wurden gemäß der oben beschriebenen Methode bestimmt. Auf diese Weise wurden Messungen der Proben 1 bis 28 vorgenommen. Die dabei nach der Untergrundkorrektur ermittelten Reflexionswerte wurden in den Tabellen 3 bis 30 wiedergegeben.

In den Tabellen 3 bis 30 wurden jeweils in der ersten Spalte die gemessenen Reflexe durchnummeriert. In Spalte 2 erfolgte die Angabe der Position der gemessenen Reflexe als 2Theta-Werte, in Spalte 3 wurden die ermittelten 2Theta-Werte mittels der Braggschen Gleichung in d-Werte für die Netzebenenabstände umgerechnet. In der vierten und fünften Spalte finden sich die Werte für die gemessenen Intensitäten (Peakhöhe der Reflexe über dem Untergrund) zum einen als absolute Werte in der Einheit "counts" [cts] sowie in ihrer relativen Intensität in Prozent.

**Tabelle 3: Probe 1: 10 g Pigment A (100 Mol-% Kupfer) nicht erfindungsgemäß**

| Peak Number | Pos. [°2Th.] | Height [cts] | d-spacing [Å] | Rel. Int. [%] |
|---|---|---|---|---|
| 1 | 7.2094 | 3642.74 | 12.26193 | 43.46 |
| 2 | 8.3268 | 792.63 | 10.61882 | 9.46 |
| 3 | 10.6297 | 757.72 | 8.32286 | 9.04 |
| 4 | 11.8561 | 722.75 | 7.46459 | 8.62 |
| 5 | 13.7967 | 1062.35 | 6.41869 | 12.67 |
| 6 | 16.6521 | 679.59 | 5.32392 | 8.11 |
| 7 | 17.2085 | 1839.19 | 5.15302 | 21.94 |
| 8 | 17.7183 | 2228.24 | 5.00588 | 26.58 |
| 9 | 18.2155 | 2078.06 | 4.87036 | 24.79 |
| 10 | 19.7576 | 421.01 | 4.49356 | 5.02 |
| 11 | 20.4804 | 541.97 | 4.33658 | 6.47 |
| 12 | 22.0776 | 351.15 | 4.02633 | 4.19 |
| 13 | 24.1154 | 1923.01 | 3.69053 | 22.94 |
| 14 | 25.9870 | 5003.44 | 3.42881 | 59.69 |
| 15 | 27.0359 | 4009.69 | 3.29812 | 47.84 |
| 16 | 27.9041 | 8382.32 | 3.19745 | 100.00 |
| 17 | 28.4884 | 5869.51 | 3.13318 | 70.02 |
| 18 | 30.3188 | 738.91 | 2.94808 | 8.82 |
| 19 | 31.3875 | 930.10 | 2.85009 | 11.10 |
| 20 | 34.6582 | 1242.15 | 2.58825 | 14.82 |
| 21 | 36.2222 | 427.46 | 2.48001 | 5.10 |
| 22 | 38.4520 | 582.54 | 2.34118 | 6.95 |

**Tabelle 4: Probe 2: 10 g Pigment B (100 Mol-% Zink) nicht erfindungsgemäß**

| Peak Number | Pos. [°2Th.] | Height [cts] | d-spacing [Å] | Rel. Int. [%] |
|---|---|---|---|---|
| 1 | 6.3948 | 2945.75 | 13.82199 | 25.63 |
| 2 | 6.8383 | 1840.02 | 12.92653 | 16.01 |
| 3 | 9.9386 | 1432.02 | 8.90002 | 12.46 |
| 4 | 10.4376 | 2712.14 | 8.47563 | 23.60 |
| 5 | 11.1586 | 735.76 | 7.92954 | 6.40 |
| 6 | 13.0241 | 449.58 | 6.79767 | 3.91 |
| 7 | 14.7483 | 528.28 | 6.00661 | 4.60 |
| 8 | 16.4912 | 1407.22 | 5.37551 | 12.24 |
| 9 | 17.3233 | 746.17 | 5.11914 | 6.49 |
| 10 | 18.1902 | 196.22 | 4.87708 | 1.71 |
| 11 | 18.6971 | 189.98 | 4.74598 | 1.65 |
| 12 | 20.0597 | 711.80 | 4.42658 | 6.19 |
| 13 | 20.8417 | 1635.72 | 4.26222 | 14.23 |
| 14 | 21.1580 | 1939.66 | 4.19920 | 16.87 |
| 15 | 24.3012 | 102.47 | 3.66272 | 0.89 |
| 16 | 25.3774 | 1833.55 | 3.50978 | 15.95 |
| 17 | 26.6634 | 10032.41 | 3.34335 | 87.28 |
| 18 | 27.0385 | 11494.33 | 3.29781 | 100.00 |
| 19 | 27.8974 | 3209.82 | 3.19821 | 27.93 |
| 20 | 28.4615 | 2477.15 | 3.13609 | 21.55 |
| 21 | 28.9166 | 1876.82 | 3.08776 | 16.33 |
| 22 | 31.3971 | 789.23 | 2.84924 | 6.87 |
| 23 | 32.0566 | 1166.28 | 2.79212 | 10.15 |
| 24 | 34.0531 | 162.92 | 2.63285 | 1.42 |
| 25 | 35.1166 | 463.91 | 2.55551 | 4.04 |
| 26 | 36.0936 | 422.32 | 2.48855 | 3.67 |
| 27 | 37.0065 | 493.27 | 2.42923 | 4.29 |

**Tabelle 5: Probe 3: 10 g Pigment C (0,5 Mol-% Kupfer / 99,5 Mol-% Zink) erfindungsgemäß**

| Peak Number | Pos. [°2Th.] | Height [cts] | d-spacing [Å] | Rel. Int. [%] |
|---|---|---|---|---|
| 1 | 6.4662 | 1350.32 | 13.65813 | 31.79 |
| 2 | 6.4823 | 675.16 | 13.65813 | 15.90 |
| 3 | 6.8350 | 2063.52 | 12.92195 | 48.58 |
| 4 | 6.8521 | 1031.76 | 12.92195 | 24.29 |
| 5 | 8.5403 | 153.75 | 10.34525 | 3.62 |
| 6 | 8.5616 | 76.88 | 10.34525 | 1.81 |
| 7 | 9.5163 | 113.98 | 9.28635 | 2.68 |
| 8 | 9.5400 | 56.99 | 9.28635 | 1.34 |
| 9 | 10.3920 | 1669.72 | 8.50568 | 39.31 |
| 10 | 10.4179 | 834.86 | 8.50568 | 19.66 |
| 11 | 11.1560 | 261.56 | 7.92481 | 6.16 |
| 12 | 11.1838 | 130.78 | 7.92481 | 3.08 |
| 13 | 12.9936 | 486.54 | 6.80789 | 11.46 |
| 14 | 13.0261 | 243.27 | 6.80789 | 5.73 |
| 15 | 14.1901 | 220.21 | 6.23645 | 5.18 |
| 16 | 14.2255 | 110.11 | 6.23645 | 2.59 |
| 17 | 14.7178 | 536.78 | 6.01402 | 12.64 |
| 18 | 14.7545 | 268.39 | 6.01402 | 6.32 |
| 19 | 15.6351 | 520.98 | 5.66317 | 12.27 |
| 20 | 15.6742 | 260.49 | 5.66317 | 6.13 |
| 21 | 16.5766 | 710.08 | 5.34359 | 16.72 |
| 22 | 16.6180 | 355.04 | 5.34359 | 8.36 |
| 23 | 16.6389 | 0.00 | 5.32372 | 0.00 |
| 24 | 16.6805 | 0.00 | 5.32372 | 0.00 |
| 25 | 17.2557 | 1245.16 | 5.13479 | 29.32 |
| 26 | 17.2989 | 622.58 | 5.13479 | 14.66 |
| 27 | 18.6134 | 477.17 | 4.76320 | 11.23 |
| 28 | 18.6600 | 238.58 | 4.76320 | 5.62 |
| 29 | 20.2603 | 686.20 | 4.37958 | 16.16 |
| 30 | 20.3111 | 343.10 | 4.37958 | 8.08 |
| 31 | 20.7787 | 2208.21 | 4.27147 | 51.99 |
| 32 | 20.8309 | 1104.10 | 4.27147 | 25.99 |
| 33 | 23.9341 | 318.53 | 3.71499 | 7.50 |
| 34 | 23.9944 | 159.26 | 3.71499 | 3.75 |
| 35 | 24.4209 | 325.56 | 3.64202 | 7.66 |
| 36 | 24.4825 | 162.78 | 3.64202 | 3.83 |
| 37 | 25.4307 | 417.95 | 3.49966 | 9.84 |
| 38 | 25.4949 | 208.97 | 3.49966 | 4.92 |
| 39 | 25.8758 | 1083.40 | 3.44045 | 25.51 |
| 40 | 25.9412 | 541.70 | 3.44045 | 12.75 |
| 41 | 26.5698 | 4247.40 | 3.35214 | 100.00 |
| 42 | 26.6370 | 2123.70 | 3.35214 | 50.00 |
| 43 | 27.0363 | 3857.50 | 3.29534 | 90.82 |
| 44 | 27.1048 | 1928.75 | 3.29534 | 45.41 |
| 45 | 27.8647 | 1630.72 | 3.19923 | 38.39 |
| 46 | 27.9354 | 815.36 | 3.19923 | 19.20 |
| 47 | 28.3962 | 1211.30 | 3.14055 | 28.52 |
| 48 | 28.4683 | 605.65 | 3.14055 | 14.26 |
| 49 | 28.8588 | 74.89 | 3.09126 | 1.76 |
| 50 | 28.9320 | 37.45 | 3.09126 | 0.88 |
| 51 | 29.1134 | 722.19 | 3.06479 | 17.00 |
| 52 | 29.1873 | 361.09 | 3.06479 | 8.50 |
| 53 | 31.3759 | 618.69 | 2.84876 | 14.57 |
| 54 | 31.4558 | 309.34 | 2.84876 | 7.28 |
| 55 | 31.7678 | 645.30 | 2.81451 | 15.19 |
| 56 | 31.8488 | 322.65 | 2.81451 | 7.60 |
| 57 | 34.8929 | 679.56 | 2.56926 | 16.00 |
| 58 | 34.9824 | 339.78 | 2.56926 | 8.00 |
| 59 | 35.0000 | 1023.02 | 2.56164 | 24.09 |
| 60 | 35.0897 | 511.51 | 2.56164 | 12.04 |
| 61 | 37.7869 | 504.11 | 2.37887 | 11.87 |
| 62 | 37.8844 | 252.06 | 2.37887 | 5.93 |

**Tabelle 6: Probe 4: 10 g Pigment D (2 Mol-% Kupfer / 98 Mol-% Zink) erfindungsgemäß**

| Peak Number | Pos. [°2Th.] | Height [cts] | d-spacing [Å] | Rel. Int. [%] |
|---|---|---|---|---|
| 1 | 6.4865 | 1495.79 | 13.61539 | 35.60 |
| 2 | 6.5027 | 747.89 | 13.61539 | 17.80 |
| 3 | 6.8367 | 1749.31 | 12.91876 | 41.64 |
| 4 | 6.8537 | 874.66 | 12.91876 | 20.82 |
| 5 | 9.7368 | 131.47 | 9.07648 | 3.13 |
| 6 | 9.7611 | 65.73 | 9.07648 | 1.56 |
| 7 | 10.3801 | 2138.01 | 8.51542 | 50.89 |
| 8 | 10.4059 | 1069.00 | 8.51542 | 25.44 |
| 9 | 11.1018 | 206.48 | 7.96339 | 4.91 |
| 10 | 11.1295 | 103.24 | 7.96339 | 2.46 |
| 11 | 13.0214 | 463.12 | 6.79342 | 11.02 |
| 12 | 13.0539 | 231.56 | 6.79342 | 5.51 |
| 13 | 14.8461 | 404.89 | 5.96232 | 9.64 |
| 14 | 14.8832 | 202.45 | 5.96232 | 4.82 |
| 15 | 15.6258 | 490.08 | 5.66652 | 11.67 |
| 16 | 15.6649 | 245.04 | 5.66653 | 5.83 |
| 17 | 16.5332 | 542.85 | 5.35749 | 12.92 |
| 18 | 16.5746 | 271.43 | 5.35749 | 6.46 |
| 19 | 17.3550 | 1050.37 | 5.10563 | 25.00 |
| 20 | 17.3984 | 525.19 | 5.10564 | 12.50 |
| 21 | 18.7393 | 375.76 | 4.73148 | 8.94 |
| 22 | 18.7863 | 187.88 | 4.73148 | 4.47 |
| 23 | 20.1724 | 603.85 | 4.39845 | 14.37 |
| 24 | 20.2231 | 301.93 | 4.39845 | 7.19 |
| 25 | 20.8650 | 2390.83 | 4.25399 | 56.91 |
| 26 | 20.9174 | 1195.41 | 4.25399 | 28.45 |
| 27 | 23.8615 | 183.54 | 3.72612 | 4.37 |
| 28 | 23.9217 | 91.77 | 3.72612 | 2.18 |
| 29 | 24.4978 | 191.49 | 3.63076 | 4.56 |
| 30 | 24.5596 | 95.75 | 3.63076 | 2.28 |
| 31 | 25.8984 | 804.22 | 3.43749 | 19.14 |
| 32 | 25.9639 | 402.11 | 3.43749 | 9.57 |
| 33 | 26.5935 | 4201.25 | 3.34921 | 100.00 |
| 34 | 26.6608 | 2100.63 | 3.34921 | 50.00 |
| 35 | 27.0564 | 3938.87 | 3.29294 | 93.75 |
| 36 | 27.1250 | 1969.43 | 3.29294 | 46.88 |
| 37 | 27.9205 | 1166.82 | 3.19297 | 27.77 |
| 38 | 27.9913 | 583.41 | 3.19297 | 13.89 |
| 39 | 28.4203 | 1077.49 | 3.13794 | 25.65 |
| 40 | 28.4924 | 538.74 | 3.13794 | 12.82 |
| 41 | 29.1652 | 739.15 | 3.05946 | 17.59 |
| 42 | 29.2393 | 369.58 | 3.05946 | 8.80 |
| 43 | 31.4118 | 853.63 | 2.84559 | 20.32 |
| 44 | 31.4919 | 426.82 | 2.84559 | 10.16 |
| 45 | 31.7296 | 675.78 | 2.81781 | 16.09 |
| 46 | 31.8105 | 337.89 | 2.81781 | 8.04 |
| 47 | 35.1799 | 829.77 | 2.54895 | 19.75 |
| 48 | 35.2702 | 414.88 | 2.54895 | 9.88 |
| 49 | 35.9647 | 140.19 | 2.49511 | 3.34 |
| 50 | 36.0571 | 70.09 | 2.49511 | 1.67 |
| 51 | 37.0041 | 100.87 | 2.42738 | 2.40 |
| 52 | 37.0993 | 50.44 | 2.42738 | 1.20 |
| 53 | 37.7306 | 432.35 | 2.38229 | 10.29 |
| 54 | 37.8279 | 216.17 | 2.38229 | 5.15 |

**Tabelle 7: Probe 5: 10 g Pigment E (6 Mol-% Kupfer / 94 Mol-% Zink) erfindungsgemäß**

| Peak Number | Pos. [°2Th.] | Height [cts] | d-spacing [Å] | Rel. Int. [%] |
|---|---|---|---|---|
| 1 | 6.4993 | 1834.79 | 13.59991 | 17.37 |
| 2 | 6.8254 | 1592.10 | 12.95096 | 15.07 |
| 3 | 10.4043 | 2436.67 | 8.50265 | 23.06 |
| 4 | 13.1235 | 365.13 | 6.74640 | 3.46 |
| 5 | 14.7362 | 253.54 | 6.01152 | 2.40 |
| 6 | 15.5446 | 226.46 | 5.70064 | 2.14 |
| 7 | 16.5915 | 749.08 | 5.34324 | 7.09 |
| 8 | 17.3267 | 585.29 | 5.11813 | 5.54 |
| 9 | 18.1634 | 326.29 | 4.88421 | 3.09 |
| 10 | 19.7732 | 456.42 | 4.49005 | 4.32 |
| 11 | 20.9688 | 2019.92 | 4.23666 | 19.12 |
| 12 | 22.0563 | 226.76 | 4.03018 | 2.15 |
| 13 | 23.8948 | 188.55 | 3.72409 | 1.78 |
| 14 | 25.4209 | 1540.54 | 3.50387 | 14.58 |
| 15 | 26.6719 | 9407.25 | 3.34231 | 89.04 |
| 16 | 27.1015 | 10564.86 | 3.29030 | 100.00 |
| 17 | 27.9074 | 4536.37 | 3.19708 | 42.94 |
| 18 | 28.4833 | 3030.81 | 3.13373 | 28.69 |
| 19 | 29.1504 | 1491.87 | 3.06352 | 14.12 |
| 20 | 31.6564 | 933.77 | 2.82649 | 8.84 |
| 21 | 35.0880 | 208.81 | 2.55753 | 1.98 |
| 22 | 37.2241 | 184.47 | 2.41553 | 1.75 |

**Tabelle 8: Probe 6: 10 g Pigment F (10 Mol-% Kupfer / 90 Mol-% Zink) erfindungsgemäß**

| Pos. [°2Th.] | Height [cts] | d-spacing [Å] | Rel. Int. [%] |
|---|---|---|---|
| 6.4530 | 2622.68 | 13.69736 | 26.66 |
| 6.9252 | 923.02 | 12.75391 | 9.38 |
| 9.4842 | 470.19 | 9.31772 | 4.78 |
| 9.9075 | 1481.10 | 8.92785 | 15.06 |
| 10.4742 | 3311.65 | 8.44607 | 33.66 |
| 10.9939 | 806.81 | 8.04129 | 8.20 |
| 13.0372 | 548.01 | 6.79086 | 5.57 |
| 14.6644 | 325.48 | 6.04077 | 3.31 |
| 15.6750 | 478.95 | 5.65353 | 4.87 |
| 16.4722 | 1333.03 | 5.38166 | 13.55 |
| 17.1866 | 455.57 | 5.15528 | 4.63 |
| 18.5264 | 172.38 | 4.78931 | 1.75 |
| 19.9554 | 756.14 | 4.44946 | 7.69 |
| 20.2573 | 652.14 | 4.38021 | 6.63 |
| 21.0952 | 2542.88 | 4.21156 | 25.85 |
| 25.3243 | 1101.67 | 3.51702 | 11.20 |
| 25.8102 | 1889.92 | 3.44905 | 19.21 |
| 26.5879 | 8340.52 | 3.35267 | 84.78 |
| 26.7826 | 7526.02 | 3.32599 | 76.50 |
| 27.1079 | 8450.38 | 3.28681 | 85.90 |
| 27.2413 | 9837.37 | 3.27373 | 100.00 |
| 29.1201 | 1437.84 | 3.06664 | 14.62 |
| 31.4399 | 924.04 | 2.84311 | 9.39 |
| 32.1768 | 1530.64 | 2.78196 | 15.56 |
| 36.1483 | 429.90 | 2.48285 | 4.37 |
| 37.2487 | 297.40 | 2.41199 | 3.02 |

**Tabelle 9: Probe 7: 10 g Pigment G (20 Mol-% Kupfer / 80 Mol-% Zink) erfindungsgemäß**

| Peak Number | Pos. [°2Th.] | Height [cts] | d-spacing [Å] | Rel. Int. [%] |
|---|---|---|---|---|
| 1 | 6.4318 | 1809.15 | 13.74256 | 27.25 |
| 2 | 7.1979 | 2460.62 | 12.28143 | 37.06 |
| 3 | 8.3278 | 372.59 | 10.61750 | 5.61 |
| 4 | 10.4132 | 2613.35 | 8.49547 | 39.36 |
| 5 | 13.0196 | 357.04 | 6.80002 | 5.38 |
| 6 | 13.8445 | 472.40 | 6.39665 | 7.12 |
| 7 | 14.6446 | 149.01 | 6.04891 | 2.24 |
| 8 | 15.5987 | 246.85 | 5.68101 | 3.72 |
| 9 | 16.7429 | 1026.28 | 5.29527 | 15.46 |
| 10 | 17.2542 | 1497.08 | 5.13948 | 22.55 |
| 11 | 17.7630 | 1019.68 | 4.99338 | 15.36 |
| 12 | 18.1909 | 1412.90 | 4.87690 | 21.28 |
| 13 | 19.7787 | 442.60 | 4.48881 | 6.67 |
| 14 | 20.9339 | 2287.15 | 4.24366 | 34.45 |
| 15 | 22.0941 | 262.75 | 4.02336 | 3.96 |
| 16 | 24.1541 | 1015.45 | 3.68470 | 15.29 |
| 17 | 25.8350 | 3085.77 | 3.44864 | 46.48 |
| 18 | 26.5067 | 6088.86 | 3.36276 | 91.71 |
| 19 | 27.2009 | 6639.46 | 3.27849 | 100.00 |
| 20 | 27.9145 | 5011.17 | 3.19629 | 75.48 |
| 21 | 28.4668 | 2595.33 | 3.13551 | 39.09 |
| 22 | 29.0268 | 1474.82 | 3.07629 | 22.21 |
| 23 | 30.2379 | 340.55 | 2.95577 | 5.13 |
| 24 | 34.6973 | 732.61 | 2.58543 | 11.03 |
| 25 | 36.1426 | 418.39 | 2.48529 | 6.30 |
| 26 | 37.3016 | 204.46 | 2.41069 | 3.08 |

**Tabelle 10: Probe 8: 10 g Pigment H (30 Mol-% Kupfer / 70 Mol-% Zink) erfindungsgemäß**

| Peak Number | Pos. [°2Th.] | Height [cts] | d-spacing [Å] | Rel. Int. [%] |
|---|---|---|---|---|
| 1 | 7.2465 | 839.77 | 12.19923 | 10.39 |
| 2 | 10.4024 | 2009.53 | 8.50424 | 24.85 |
| 3 | 12.9987 | 211.27 | 6.81088 | 2.61 |
| 4 | 17.2743 | 689.77 | 5.13355 | 8.53 |
| 5 | 18.2038 | 640.10 | 4.87345 | 7.92 |
| 6 | 19.7769 | 361.32 | 4.48923 | 4.47 |
| 7 | 21.1550 | 1480.58 | 4.19979 | 18.31 |
| 8 | 22.0575 | 412.22 | 4.02996 | 5.10 |
| 9 | 23.9960 | 367.27 | 3.70861 | 4.54 |
| 10 | 26.7289 | 8085.33 | 3.33531 | 100.00 |
| 11 | 27.8892 | 5468.39 | 3.19913 | 67.63 |
| 12 | 28.4829 | 4107.54 | 3.13378 | 50.80 |
| 13 | 31.7750 | 629.00 | 2.81622 | 7.78 |

**Tabelle 11: Probe 9: 10 g Pigment I (40 Mol-% Kupfer / 60 Mol-% Zink) erfindungsgemäß**

| Peak Number | Pos. [°2Th.] | Height [cts] | d-spacing [Å] | Rel. Int. [%] |
|---|---|---|---|---|
| 1 | 7.2160 | 2505.24 | 12.25076 | 35.61 |
| 2 | 8.3038 | 423.45 | 10.64821 | 6.02 |
| 3 | 10.3767 | 1319.28 | 8.52523 | 18.75 |
| 4 | 11.7975 | 363.79 | 7.50153 | 5.17 |
| 5 | 13.7891 | 530.80 | 6.42222 | 7.54 |
| 6 | 17.1853 | 1499.95 | 5.15993 | 21.32 |
| 7 | 17.7002 | 1495.99 | 5.01096 | 21.26 |
| 8 | 18.2223 | 1616.47 | 4.86856 | 22.97 |
| 9 | 19.7580 | 368.15 | 4.49348 | 5.23 |
| 10 | 21.0471 | 940.23 | 4.22108 | 13.36 |
| 11 | 24.0658 | 1160.97 | 3.69802 | 16.50 |
| 12 | 25.9115 | 4513.48 | 3.43864 | 64.15 |
| 13 | 26.6663 | 5932.97 | 3.34300 | 84.32 |
| 14 | 27.1478 | 6640.73 | 3.28479 | 94.38 |
| 15 | 27.9400 | 7036.01 | 3.19343 | 100.00 |
| 16 | 28.4768 | 3829.50 | 3.13444 | 54.43 |
| 17 | 30.3014 | 314.02 | 2.94972 | 4.46 |
| 18 | 31.4059 | 471.53 | 2.84847 | 6.70 |
| 19 | 34.5304 | 868.64 | 2.59754 | 12.35 |
| 20 | 36.2126 | 371.59 | 2.48064 | 5.28 |
| 21 | 38.5100 | 369.75 | 2.33778 | 5.26 |

**Tabelle 12: Probe 10: 10 g Pigment J (50 Mol-% Kupfer / 50 Mol-% Zink) erfindungsgemäß**

| Nr. | Pos. [°2Th.] | d-spacing [Å] | Int. Height [cts] | Rel. Int. [%] |
|---|---|---|---|---|
| 1 | 6,2732 | 14,08953 | 804,83 | 11,00 |
| 2 | 7,1870 | 12,30003 | 2194,78 | 29,99 |
| 3 | 8,3666 | 10,56840 | 363,82 | 4,97 |
| 4 | 10,4807 | 8,44086 | 1304,23 | 17,82 |
| 5 | 11,8041 | 7,49734 | 261,50 | 3,57 |
| 6 | 13,7999 | 6,41720 | 531,71 | 7,27 |
| 7 | 16,7948 | 5,27463 | 683,70 | 9,34 |
| 8 | 17,2367 | 5,14467 | 1404,77 | 19,19 |
| 9 | 17,7103 | 5,00813 | 1454,34 | 19,87 |
| 10 | 18,2340 | 4,86545 | 1290,74 | 17,64 |
| 11 | 19,6835 | 4,50658 | 356,50 | 4,87 |
| 12 | 20,5450 | 4,31951 | 376,83 | 5,15 |
| 13 | 21,0971 | 4,21120 | 798,88 | 10,92 |
| 14 | 23,7630 | 3,74134 | 686,55 | 9,38 |
| 15 | 24,1251 | 3,68906 | 1055,22 | 14,42 |
| 16 | 25,9349 | 3,43559 | 4319,19 | 59,02 |
| 17 | 26,6771 | 3,33890 | 4975,72 | 67,99 |
| 18 | 27,1252 | 3,28748 | 7318,60 | 100,00 |
| 19 | 27,8720 | 3,20106 | 6576,43 | 89,86 |
| 20 | 29,0601 | 3,07030 | 919,93 | 12,57 |
| 21 | 30,3544 | 2,94470 | 271,94 | 3,72 |
| 22 | 31,2666 | 2,86083 | 327,73 | 4,48 |
| 23 | 32,2201 | 2,77832 | 260,10 | 3,55 |
| 24 | 34,6795 | 2,58671 | 835,41 | 11,41 |
| 25 | 36,2522 | 2,47803 | 322,18 | 4,40 |
| 26 | 38,5761 | 2,33393 | 287,14 | 3,92 |
| 27 | 39,3726 | 2,28664 | 576,73 | 7,88 |

**Tabelle 13: Probe 11: 10 g Pigment K (60 Mol-% Kupfer / 40 Mol-% Zink) erfindungsgemäß**

| Peak Number | Pos. [°2Th.] | Height [cts] | d-spacing [Å] | Rel. Int. [%] |
|---|---|---|---|---|
| 1 | 7.1942 | 4334.39 | 12.28776 | 49.32 |
| 2 | 8.3526 | 913.07 | 10.58612 | 10.39 |
| 3 | 10.5617 | 1111.77 | 8.37634 | 12.65 |
| 4 | 11.8238 | 646.03 | 7.48490 | 7.35 |
| 5 | 13.8690 | 1215.75 | 6.38537 | 13.83 |
| 6 | 16.7383 | 839.74 | 5.29670 | 9.56 |
| 7 | 17.2791 | 2258.55 | 5.13212 | 25.70 |
| 8 | 17.7572 | 2404.86 | 4.99502 | 27.37 |
| 9 | 18.2569 | 2554.71 | 4.85941 | 29.07 |
| 10 | 19.7734 | 455.44 | 4.49000 | 5.18 |
| 11 | 20.5717 | 677.23 | 4.31755 | 7.71 |
| 12 | 21.3784 | 577.84 | 4.15642 | 6.58 |
| 13 | 24.1487 | 2200.73 | 3.68550 | 25.04 |
| 14 | 25.8557 | 5113.57 | 3.44593 | 58.19 |
| 15 | 26.9017 | 5336.03 | 3.31427 | 60.72 |
| 16 | 27.9201 | 8787.95 | 3.19566 | 100.00 |
| 17 | 28.4870 | 3457.22 | 3.13334 | 39.34 |
| 18 | 29.0902 | 1258.48 | 3.06973 | 14.32 |
| 19 | 30.1296 | 653.52 | 2.96615 | 7.44 |
| 20 | 31.3075 | 842.18 | 2.85719 | 9.58 |
| 21 | 34.6400 | 1515.97 | 2.58957 | 17.25 |
| 22 | 36.2508 | 625.85 | 2.47812 | 7.12 |
| 23 | 38.5389 | 606.78 | 2.33610 | 6.90 |
| 24 | 39.3680 | 685.76 | 2.28879 | 7.80 |

**Tabelle 14: Probe 12: 10 g Pigment L (70 Mol-% Kupfer / 30 Mol-% Zink) erfindungsgemäß**

| Nr. | Pos. [°2Th.] | d-spacing [Å] | Int. Height [cts] | Rel. Int. [%] |
|---|---|---|---|---|
| 1 | 7,2381 | 12,21334 | 3538,10 | 36,16 |
| 2 | 8,2945 | 10,66011 | 948,31 | 9,69 |
| 3 | 10,4759 | 8,44468 | 818,21 | 8,36 |
| 4 | 11,7706 | 7,51862 | 605,31 | 6,19 |
| 5 | 13,8323 | 6,40226 | 1253,65 | 12,81 |
| 6 | 16,7286 | 5,29975 | 755,47 | 7,72 |
| 7 | 17,2389 | 5,14401 | 2067,38 | 21,13 |
| 8 | 17,7581 | 4,99475 | 2419,24 | 24,73 |
| 9 | 18,2050 | 4,87314 | 2271,13 | 23,21 |
| 10 | 19,6982 | 4,50698 | 225,66 | 2,31 |
| 11 | 20,5009 | 4,33230 | 502,05 | 5,13 |
| 12 | 21,1611 | 4,19861 | 450,80 | 4,61 |
| 13 | 23,7124 | 3,74921 | 972,47 | 9,94 |
| 14 | 24,1520 | 3,68501 | 1989,55 | 20,34 |
| 15 | 25,8012 | 3,45308 | 5571,69 | 56,95 |
| 16 | 26,8777 | 3,31718 | 5658,41 | 57,84 |
| 17 | 27,3613 | 3,25694 | 5394,11 | 55,13 |
| 18 | 27,9211 | 3,19554 | 9783,61 | 100,00 |
| 19 | 28,0976 | 3,17588 | 8985,70 | 91,84 |
| 20 | 29,0108 | 3,07795 | 1495,48 | 15,29 |
| 21 | 30,1968 | 2,95971 | 660,86 | 6,75 |
| 22 | 31,2275 | 2,86433 | 960,62 | 9,82 |
| 23 | 34,6924 | 2,58578 | 1562,70 | 15,97 |
| 24 | 36,1986 | 2,48157 | 639,50 | 6,54 |
| 25 | 38,5428 | 2,33586 | 774,06 | 7,91 |
| 26 | 39,3966 | 2,28719 | 847,60 | 8,66 |

**Tabelle 15: Probe 13: 10 g Pigment M (80 Mol-% Kupfer / 20 Mol-% Zink) erfindungsgemäß**

| Peak Number | Pos. [°2Th.] | Height [cts] | d-spacing [Å] | Rel. Int. [%] |
|---|---|---|---|---|
| 1 | 7.2452 | 5584.85 | 12.20138 | 47.31 |
| 2 | 8.3279 | 1422.27 | 10.61745 | 12.05 |
| 3 | 10.4539 | 410.84 | 8.46248 | 3.48 |
| 4 | 11.8250 | 1014.45 | 7.48413 | 8.59 |
| 5 | 13.8696 | 1679.44 | 6.38513 | 14.23 |
| 6 | 15.1190 | 444.66 | 5.86014 | 3.77 |
| 7 | 16.7733 | 916.00 | 5.28574 | 7.76 |
| 8 | 17.3050 | 2941.68 | 5.12449 | 24.92 |
| 9 | 17.8126 | 2939.18 | 4.97961 | 24.90 |
| 10 | 18.2778 | 3241.31 | 4.85391 | 27.46 |
| 11 | 19.7499 | 368.02 | 4.49529 | 3.12 |
| 12 | 20.5220 | 518.33 | 4.32788 | 4.39 |
| 13 | 24.1354 | 3005.62 | 3.68750 | 25.46 |
| 14 | 25.8077 | 6285.92 | 3.45224 | 53.25 |
| 15 | 27.9581 | 11804.72 | 3.19140 | 100.00 |
| 16 | 28.9844 | 1423.98 | 3.08069 | 12.06 |
| 17 | 30.2000 | 1337.63 | 2.95940 | 11.33 |
| 18 | 31.2509 | 1650.82 | 2.86224 | 13.98 |
| 19 | 34.6827 | 2123.10 | 2.58649 | 17.99 |
| 20 | 36.2115 | 967.86 | 2.48072 | 8.20 |
| 21 | 38.5854 | 1070.24 | 2.33339 | 9.07 |
| 22 | 39.4198 | 1271.87 | 2.28590 | 10.77 |

**Tabelle 16: Probe 14: 10 g Pigment N (90 Mol-% Kupfer / 10 Mol-% Zink) erfindungsgemäß**

| Peak Number | Pos. [°2Th.] | Height [cts] | d-spacing [Å] | Rel. Int. [%] |
|---|---|---|---|---|
| 1 | 7.2063 | 3726.37 | 12.26723 | 47.84 |
| 2 | 8.3093 | 813.32 | 10.64118 | 10.44 |
| 3 | 10.6160 | 865.28 | 8.33359 | 11.11 |
| 4 | 11.8913 | 640.74 | 7.44258 | 8.23 |
| 5 | 13.8368 | 1010.08 | 6.40016 | 12.97 |
| 6 | 17.2470 | 1987.98 | 5.14162 | 25.52 |
| 7 | 17.7113 | 2302.02 | 5.00785 | 29.55 |
| 8 | 18.2312 | 2162.71 | 4.86620 | 27.76 |
| 9 | 19.7865 | 406.44 | 4.48708 | 5.22 |
| 10 | 20.5328 | 641.20 | 4.32564 | 8.23 |
| 11 | 22.0205 | 326.95 | 4.03664 | 4.20 |
| 12 | 24.0045 | 1930.67 | 3.70732 | 24.78 |
| 13 | 25.9058 | 4685.83 | 3.43938 | 60.15 |
| 14 | 26.8813 | 3889.93 | 3.31674 | 49.94 |
| 15 | 27.9278 | 7789.96 | 3.19480 | 100.00 |
| 16 | 28.2064 | 7141.40 | 3.16387 | 91.67 |
| 17 | 28.4922 | 5608.59 | 3.13278 | 72.00 |
| 18 | 30.4860 | 593.22 | 2.93228 | 7.62 |
| 19 | 31.4790 | 814.43 | 2.84202 | 10.45 |
| 20 | 34.5788 | 1228.47 | 2.59402 | 15.77 |
| 21 | 36.1001 | 299.45 | 2.48812 | 3.84 |
| 22 | 38.4758 | 549.23 | 2.33978 | 7.05 |

**Tabelle 17: Probe 15: 10 g Pigment O (94 Mol-% Kupfer / 6 Mol-% Zink) erfindungsgemäß**

| Peak Number | Pos. [°2Th.] | Height [cts] | d-spacing [Å] | Rel. Int. [%] |
|---|---|---|---|---|
| 1 | 7.1967 | 5435.33 | 12.28359 | 53.30 |
| 2 | 8.3413 | 1366.32 | 10.60033 | 13.40 |
| 3 | 10.5711 | 668.43 | 8.36887 | 6.55 |
| 4 | 11.8382 | 872.14 | 7.47584 | 8.55 |
| 5 | 13.8740 | 1491.54 | 6.38309 | 14.63 |
| 6 | 16.7811 | 865.60 | 5.28329 | 8.49 |
| 7 | 17.2674 | 2706.97 | 5.13557 | 26.54 |
| 8 | 17.7593 | 3074.07 | 4.99443 | 30.14 |
| 9 | 18.2613 | 2969.43 | 4.85826 | 29.12 |
| 10 | 19.7707 | 582.04 | 4.49062 | 5.71 |
| 11 | 20.5533 | 515.91 | 4.32136 | 5.06 |
| 12 | 21.9760 | 262.96 | 4.04471 | 2.58 |
| 13 | 24.1576 | 2687.10 | 3.68417 | 26.35 |
| 14 | 25.8206 | 5230.21 | 3.45053 | 51.28 |
| 15 | 26.8646 | 3746.17 | 3.31876 | 36.73 |
| 16 | 27.9186 | 10198.52 | 3.19583 | 100.00 |
| 17 | 28.5034 | 4939.11 | 3.13157 | 48.43 |
| 18 | 30.2582 | 1050.35 | 2.95384 | 10.30 |
| 19 | 31.3156 | 1348.81 | 2.85648 | 13.23 |
| 20 | 34.6446 | 1643.91 | 2.58924 | 16.12 |
| 21 | 36.1779 | 678.78 | 2.48294 | 6.66 |
| 22 | 38.5718 | 770.05 | 2.33418 | 7.55 |
| 23 | 39.4562 | 866.78 | 2.28387 | 8.50 |

**Tabelle 18: Probe 16: 0,05 g Pigment A und 9,95 g Pigment B (physikalische Mischung 0,5 Mol-% Kupfer und 99,5 Mol-% Zink) erfindungsgemäß**

| Peak Number | Pos. [°2Th.] | Height [cts] | d-spacing [Å] | Rel. Int. [%] |
|---|---|---|---|---|
| 1 | 5.0066 | 374.72 | 17.63641 | 6.06 |
| 2 | 5.0190 | 187.36 | 17.63641 | 3.03 |
| 3 | 6.4673 | 673.11 | 13.65597 | 10.88 |
| 4 | 6.4833 | 336.55 | 13.65597 | 5.44 |
| 5 | 10.3592 | 869.13 | 8.53252 | 14.04 |
| 6 | 10.3850 | 434.57 | 8.53252 | 7.02 |
| 7 | 12.5982 | 67.62 | 7.02066 | 1.09 |
| 8 | 12.6296 | 33.81 | 7.02066 | 0.55 |
| 9 | 15.2012 | 785.61 | 5.82381 | 12.69 |
| 10 | 15.2392 | 392.80 | 5.82381 | 6.35 |
| 11 | 16.8993 | 528.20 | 5.24226 | 8.54 |
| 12 | 16.9416 | 264.10 | 5.24226 | 4.27 |
| 13 | 18.7815 | 180.54 | 4.72093 | 2.92 |
| 14 | 18.8286 | 90.27 | 4.72093 | 1.46 |
| 15 | 20.8140 | 743.54 | 4.26429 | 12.02 |
| 16 | 20.8663 | 371.77 | 4.26429 | 6.01 |
| 17 | 25.6520 | 729.96 | 3.46996 | 11.80 |
| 18 | 25.7168 | 364.98 | 3.46996 | 5.90 |
| 19 | 27.2340 | 6188.34 | 3.27187 | 100.00 |
| 20 | 27.3030 | 3094.17 | 3.27187 | 50.00 |
| 21 | 27.8257 | 2248.19 | 3.20363 | 36.33 |
| 22 | 27.8963 | 1124.10 | 3.20363 | 18.16 |
| 23 | 31.4610 | 186.15 | 2.84125 | 3.01 |
| 24 | 31.5412 | 93.07 | 2.84125 | 1.50 |
| 25 | 34.9445 | 428.56 | 2.56558 | 6.93 |
| 26 | 35.0341 | 214.28 | 2.56558 | 3.46 |
| 27 | 36.0103 | 529.81 | 2.49205 | 8.56 |
| 28 | 36.1028 | 264.90 | 2.49205 | 4.28 |

**Tabelle 19: Probe 17: 0,2 g Pigment A und 9,8 g Pigment B (physikalische Mischung 2 Mol-% Kupfer und 98 Mol-% Zink) erfindungsgemäß**

| Peak Number | Pos. [°2Th.] | Height [cts] | d-spacing [Å] | Rel. Int. [%] |
|---|---|---|---|---|
| 1 | 5.4731 | 0.00 | 16.13407 | 0.00 |
| 2 | 5.4867 | 0.00 | 16.13407 | 0.00 |
| 3 | 6.4249 | 626.16 | 13.74600 | 8.59 |
| 4 | 6.4408 | 313.08 | 13.74600 | 4.30 |
| 5 | 10.3096 | 841.56 | 8.57346 | 11.55 |
| 6 | 10.3353 | 420.78 | 8.57346 | 5.77 |
| 7 | 15.1837 | 732.31 | 5.83051 | 10.05 |
| 8 | 15.2216 | 366.16 | 5.83051 | 5.02 |
| 9 | 16.9792 | 476.51 | 5.21776 | 6.54 |
| 10 | 17.0217 | 238.26 | 5.21776 | 3.27 |
| 11 | 18.7871 | 158.94 | 4.71953 | 2.18 |
| 12 | 18.8343 | 79.47 | 4.71953 | 1.09 |
| 13 | 20.4050 | 386.58 | 4.34883 | 5.30 |
| 14 | 20.4563 | 193.29 | 4.34883 | 2.65 |
| 15 | 20.8641 | 565.41 | 4.25416 | 7.76 |
| 16 | 20.9165 | 282.70 | 4.25416 | 3.88 |
| 17 | 23.8660 | 77.00 | 3.72544 | 1.06 |
| 18 | 23.9261 | 38.50 | 3.72544 | 0.53 |
| 19 | 25.8584 | 1070.60 | 3.44272 | 14.69 |
| 20 | 25.9238 | 535.30 | 3.44272 | 7.34 |
| 21 | 27.2348 | 7288.96 | 3.27178 | 100.00 |
| 22 | 27.3038 | 3644.48 | 3.27178 | 50.00 |
| 23 | 28.1653 | 1934.59 | 3.16577 | 26.54 |
| 24 | 28.2368 | 967.30 | 3.16577 | 13.27 |
| 25 | 31.4736 | 179.11 | 2.84014 | 2.46 |
| 26 | 31.5539 | 89.55 | 2.84014 | 1.23 |
| 27 | 34.6548 | 328.27 | 2.58636 | 4.50 |
| 28 | 34.7436 | 164.13 | 2.58636 | 2.25 |
| 29 | 36.0524 | 448.34 | 2.48924 | 6.15 |
| 30 | 36.1451 | 224.17 | 2.48924 | 3.08 |

**Tabelle 20: Probe 18: 0,6 g Pigment A und 9,4 g Pigment B (physikalische Mischung 6 Mol-% Kupfer und 94 Mol-% Zink) erfindungsgemäß**

| Peak Number | Pos. [°2Th.] | Height [cts] | d-spacing [Å] | Rel. Int. [%] |
|---|---|---|---|---|
| 1 | 6.3313 | 2281.58 | 13.96036 | 16.53 |
| 2 | 10.3842 | 2417.90 | 8.51912 | 17.51 |
| 3 | 11.1569 | 648.44 | 7.93074 | 4.70 |
| 4 | 12.9719 | 359.22 | 6.82490 | 2.60 |
| 5 | 14.8173 | 410.12 | 5.97881 | 2.97 |
| 6 | 15.4724 | 257.94 | 5.72709 | 1.87 |
| 7 | 16.4361 | 1033.65 | 5.39342 | 7.49 |
| 8 | 17.3462 | 558.26 | 5.11243 | 4.04 |
| 9 | 18.1871 | 266.28 | 4.87790 | 1.93 |
| 10 | 20.0569 | 704.88 | 4.42719 | 5.11 |
| 11 | 20.8790 | 1920.46 | 4.25468 | 13.91 |
| 12 | 22.0595 | 317.86 | 4.02960 | 2.30 |
| 13 | 24.0310 | 157.82 | 3.70330 | 1.14 |
| 14 | 25.3343 | 1757.45 | 3.51566 | 12.73 |
| 15 | 26.5444 | 10318.39 | 3.35807 | 74.75 |
| 16 | 27.0838 | 13804.76 | 3.29240 | 100.00 |
| 17 | 27.8872 | 3794.16 | 3.19935 | 27.48 |
| 18 | 28.4839 | 2779.37 | 3.13367 | 20.13 |
| 19 | 28.9531 | 1950.87 | 3.08394 | 14.13 |
| 20 | 31.4723 | 876.32 | 2.84260 | 6.35 |
| 21 | 32.0291 | 1042.57 | 2.79445 | 7.55 |
| 22 | 35.0939 | 349.26 | 2.55711 | 2.53 |
| 23 | 36.0890 | 318.86 | 2.48885 | 2.31 |
| 24 | 37.0793 | 361.23 | 2.42463 | 2.62 |

**Tabelle 21: Probe 19: 1,0 g Pigment A und 9,0 g Pigment B (physikalische Mischung 10 Mol-% Kupfer und 90 Mol-% Zink) erfindungsgemäß**

| Peak Number | Pos. [°2Th.] | Height [cts] | d-spacing [Å] | Rel. Int. [%] |
|---|---|---|---|---|
| 1 | 6.3918 | 2474.85 | 13.82851 | 20.74 |
| 2 | 6.9854 | 1321.60 | 12.65458 | 11.07 |
| 3 | 10.4135 | 2440.69 | 8.49518 | 20.45 |
| 4 | 11.1861 | 664.52 | 7.91014 | 5.57 |
| 5 | 12.9088 | 274.63 | 6.85814 | 2.30 |
| 6 | 14.6503 | 348.64 | 6.04658 | 2.92 |
| 7 | 15.4626 | 282.44 | 5.73072 | 2.37 |
| 8 | 16.4162 | 1059.97 | 5.39990 | 8.88 |
| 9 | 17.3533 | 635.30 | 5.11036 | 5.32 |
| 10 | 18.1701 | 334.49 | 4.88242 | 2.80 |
| 11 | 20.0092 | 660.46 | 4.43762 | 5.53 |
| 12 | 20.8438 | 1830.25 | 4.26180 | 15.34 |
| 13 | 21.2291 | 1419.21 | 4.18530 | 11.89 |
| 14 | 22.0699 | 204.97 | 4.02772 | 1.72 |
| 15 | 23.9551 | 190.05 | 3.71485 | 1.59 |
| 16 | 25.3712 | 1823.51 | 3.51062 | 15.28 |
| 17 | 26.4857 | 8910.41 | 3.36538 | 74.67 |
| 18 | 27.2073 | 11933.22 | 3.27773 | 100.00 |
| 19 | 27.8934 | 3988.06 | 3.19866 | 33.42 |
| 20 | 28.4803 | 2990.24 | 3.13406 | 25.06 |
| 21 | 29.0148 | 1880.99 | 3.07753 | 15.76 |
| 22 | 31.4455 | 796.83 | 2.84496 | 6.68 |
| 23 | 32.0576 | 1010.25 | 2.79203 | 8.47 |
| 24 | 35.1343 | 254.22 | 2.55426 | 2.13 |
| 25 | 36.0968 | 295.22 | 2.48834 | 2.47 |
| 26 | 37.0593 | 249.71 | 2.42589 | 2.09 |

**Tabelle 22: Probe 20: 2,0 g Pigment A und 8,0 g Pigment B (physikalische Mischung 20 Mol-% Kupfer und 80 Mol-% Zink) erfindungsgemäß**

| Peak Number | Pos. [°2Th.] | Height [cts] | d-spacing [Å] | Rel. Int. [%] |
|---|---|---|---|---|
| 1 | 6.3455 | 2165.11 | 13.92925 | 18.32 |
| 2 | 7.2136 | 1173.73 | 12.25482 | 9.93 |
| 3 | 8.2939 | 118.81 | 10.66086 | 1.01 |
| 4 | 10.5679 | 2040.81 | 8.37140 | 17.27 |
| 5 | 12.8576 | 222.61 | 6.88533 | 1.88 |
| 6 | 14.7343 | 359.54 | 6.01228 | 3.04 |
| 7 | 15.4652 | 314.43 | 5.72975 | 2.66 |
| 8 | 16.4152 | 977.72 | 5.40022 | 8.27 |
| 9 | 17.2837 | 818.65 | 5.13078 | 6.93 |
| 10 | 18.1656 | 424.24 | 4.88362 | 3.59 |
| 11 | 20.0170 | 621.01 | 4.43591 | 5.25 |
| 12 | 20.9157 | 1734.87 | 4.24730 | 14.68 |
| 13 | 24.0644 | 454.26 | 3.69822 | 3.84 |
| 14 | 26.5944 | 9461.71 | 3.35187 | 80.06 |
| 15 | 27.0564 | 11818.96 | 3.29568 | 100.00 |
| 16 | 27.2638 | 9590.21 | 3.27107 | 81.14 |
| 17 | 27.8687 | 4611.58 | 3.20144 | 39.02 |
| 18 | 28.5040 | 3147.95 | 3.13151 | 26.63 |
| 19 | 28.9624 | 1854.81 | 3.08298 | 15.69 |
| 20 | 30.1756 | 231.46 | 2.96174 | 1.96 |
| 21 | 31.4362 | 783.69 | 2.84579 | 6.63 |
| 22 | 32.0438 | 861.63 | 2.79320 | 7.29 |
| 23 | 36.0798 | 175.14 | 2.48947 | 1.48 |
| 24 | 37.2340 | 196.04 | 2.41491 | 1.66 |

**Tabelle 23: Probe 21: 3,0 g Pigment A und 7,0 g Pigment B (physikalische Mischung 30 Mol-% Kupfer und 70 Mol-% Zink) erfindungsgemäß**

| Peak Number | Pos. [°2Th.] | Height [cts] | d-spacing [Å] | Rel. Int. [%] |
|---|---|---|---|---|
| 1 | 6.3250 | 1818.51 | 13.97425 | 17.95 |
| 2 | 7.2050 | 1458.99 | 12.26935 | 14.40 |
| 3 | 8.2931 | 184.80 | 10.66187 | 1.82 |
| 4 | 10.4644 | 1952.88 | 8.45397 | 19.28 |
| 5 | 11.1671 | 523.75 | 7.92353 | 5.17 |
| 6 | 12.9654 | 181.88 | 6.82830 | 1.80 |
| 7 | 13.8842 | 237.61 | 6.37843 | 2.35 |
| 8 | 14.6810 | 200.05 | 6.03400 | 1.97 |
| 9 | 15.5460 | 171.22 | 5.70015 | 1.69 |
| 10 | 16.4167 | 736.95 | 5.39975 | 7.27 |
| 11 | 17.2909 | 815.92 | 5.12865 | 8.05 |
| 12 | 18.2217 | 618.48 | 4.86871 | 6.10 |
| 13 | 19.8884 | 444.39 | 4.46430 | 4.39 |
| 14 | 20.8561 | 1513.35 | 4.25931 | 14.94 |
| 15 | 21.1659 | 1323.04 | 4.19765 | 13.06 |
| 16 | 22.0775 | 316.14 | 4.02636 | 3.12 |
| 17 | 24.0645 | 626.53 | 3.69820 | 6.18 |
| 18 | 25.8317 | 3633.82 | 3.44908 | 35.87 |
| 19 | 26.6610 | 9483.99 | 3.34365 | 93.61 |
| 20 | 27.2262 | 10131.38 | 3.27551 | 100.00 |
| 21 | 27.9040 | 5236.33 | 3.19747 | 51.68 |
| 22 | 28.5297 | 3349.69 | 3.12874 | 33.06 |
| 23 | 29.0755 | 1635.13 | 3.07125 | 16.14 |
| 24 | 30.2617 | 165.40 | 2.95350 | 1.63 |
| 25 | 31.4905 | 777.58 | 2.84100 | 7.67 |
| 26 | 32.0845 | 736.64 | 2.78975 | 7.27 |
| 27 | 34.7143 | 163.32 | 2.58420 | 1.61 |
| 28 | 36.2290 | 190.10 | 2.47956 | 1.88 |

**Tabelle 24: Probe 22: 4,0 g Pigment A und 6,0 g Pigment B (physikalische Mischung 40 Mol-% Kupfer und 60 Mol-% Zink) erfindungsgemäß**

| Peak Number | Pos. [°2Th.] | Height [cts] | d-spacing [Å] | Rel. Int. [%] |
|---|---|---|---|---|
| | | | | |
| 1 | 6.3250 | 1508.06 | 13.97441 | 14.99 |
| 2 | 7.1844 | 1743.33 | 12.30455 | 17.33 |
| 3 | 8.2928 | 250.38 | 10.66232 | 2.49 |
| 4 | 10.4673 | 1742.73 | 8.45165 | 17.32 |
| 5 | 11.8397 | 185.62 | 7.47485 | 1.84 |
| 6 | 13.8264 | 422.22 | 6.40497 | 4.20 |
| 7 | 14.8186 | 174.77 | 5.97829 | 1.74 |
| 8 | 16.4236 | 688.34 | 5.39748 | 6.84 |
| 9 | 17.2602 | 1019.38 | 5.13770 | 10.13 |
| 10 | 18.1871 | 875.43 | 4.87790 | 8.70 |
| 11 | 19.8064 | 500.74 | 4.48261 | 4.98 |
| 12 | 20.9140 | 1432.78 | 4.24764 | 14.24 |
| 13 | 22.0695 | 361.20 | 4.02780 | 3.59 |
| 14 | 24.1232 | 758.91 | 3.68934 | 7.54 |
| 15 | 25.9586 | 4206.87 | 3.43250 | 41.81 |
| 16 | 26.5856 | 8118.70 | 3.35295 | 80.69 |
| 17 | 27.1130 | 10061.49 | 3.28892 | 100.00 |
| 18 | 27.9092 | 5977.85 | 3.19688 | 59.41 |
| 19 | 28.4844 | 4292.48 | 3.13362 | 42.66 |
| 20 | 30.2620 | 163.71 | 2.95347 | 1.63 |
| 21 | 31.4295 | 701.52 | 2.84638 | 6.97 |
| 22 | 34.6677 | 370.54 | 2.58757 | 3.68 |
| 23 | 36.1038 | 224.89 | 2.48787 | 2.24 |

**Tabelle 25: Probe 23: 5,0 g Pigment A und 5,0 g Pigment B (physikalische Mischung 50 Mol-% Kupfer und 50 Mol-% Zink) erfindungsgemäß**

| Peak Number | Pos. [°2Th.] | Height [cts] | d-spacing [Å] | Rel. Int. [%] |
|---|---|---|---|---|
| 1 | 6.3742 | 1355.88 | 13.86652 | 15.72 |
| 2 | 7.1873 | 2059.97 | 12.29963 | 23.88 |
| 3 | 8.2935 | 353.91 | 10.66134 | 4.10 |
| 4 | 10.4341 | 1571.82 | 8.47845 | 18.22 |
| 5 | 11.8007 | 244.96 | 7.49951 | 2.84 |
| 6 | 13.8218 | 528.23 | 6.40707 | 6.12 |
| 7 | 15.1311 | 44.49 | 5.85550 | 0.52 |
| 8 | 16.4619 | 633.01 | 5.38499 | 7.34 |
| 9 | 17.2531 | 1243.56 | 5.13981 | 14.41 |
| 10 | 17.6754 | 1052.68 | 5.01794 | 12.20 |
| 11 | 18.1849 | 1171.93 | 4.87847 | 13.58 |
| 12 | 19.7557 | 469.43 | 4.49399 | 5.44 |
| 13 | 20.9425 | 1159.52 | 4.24192 | 13.44 |
| 14 | 22.0609 | 358.15 | 4.02934 | 4.15 |
| 15 | 24.0658 | 1053.46 | 3.69801 | 12.21 |
| 16 | 25.8945 | 4308.45 | 3.44085 | 49.94 |
| 17 | 26.6391 | 7590.42 | 3.34634 | 87.98 |
| 18 | 27.1420 | 8627.25 | 3.28548 | 100.00 |
| 19 | 27.8921 | 6462.61 | 3.19880 | 74.91 |
| 20 | 28.4615 | 4575.92 | 3.13609 | 53.04 |
| 21 | 30.2165 | 268.95 | 2.95782 | 3.12 |
| 22 | 31.3439 | 653.41 | 2.85396 | 7.57 |
| 23 | 34.6228 | 599.36 | 2.59082 | 6.95 |
| 24 | 36.1290 | 249.92 | 2.48619 | 2.90 |

**Tabelle 26: Probe 24: 6,0 g Pigment A und 4,0 g Pigment B (physikalische Mischung 60 Mol-% Kupfer und 40 Mol-% Zink) erfindungsgemäß**

| Peak Number | Pos. [°2Th.] | Height [cts] | d-spacing [Å] | Rel. Int. [%] |
|---|---|---|---|---|
| 1 | 6.3520 | 1229.59 | 13.91507 | 16.30 |
| 2 | 7.1968 | 2358.90 | 12.28342 | 31.26 |
| 3 | 8.3004 | 395.71 | 10.65251 | 5.24 |
| 4 | 10.5076 | 1355.50 | 8.41928 | 17.97 |
| 5 | 11.8277 | 292.39 | 7.48241 | 3.88 |
| 6 | 13.8333 | 549.29 | 6.40178 | 7.28 |
| 7 | 16.6425 | 718.48 | 5.32698 | 9.52 |
| 8 | 17.2620 | 1298.64 | 5.13718 | 17.21 |
| 9 | 17.7257 | 1352.88 | 5.00383 | 17.93 |
| 10 | 18.2151 | 1304.32 | 4.87047 | 17.29 |
| 11 | 21.0892 | 942.04 | 4.21275 | 12.49 |
| 12 | 22.0678 | 408.59 | 4.02809 | 5.42 |
| 13 | 24.0734 | 1163.83 | 3.69686 | 15.42 |
| 14 | 25.8980 | 4266.75 | 3.44040 | 56.55 |
| 15 | 26.6216 | 6502.72 | 3.34851 | 86.18 |
| 16 | 27.1347 | 7545.20 | 3.28634 | 100.00 |
| 17 | 27.9116 | 6734.56 | 3.19661 | 89.26 |
| 18 | 28.5050 | 4578.78 | 3.13140 | 60.68 |
| 19 | 30.2617 | 317.49 | 2.95350 | 4.21 |
| 20 | 31.4265 | 724.66 | 2.84664 | 9.60 |
| 21 | 34.5843 | 600.53 | 2.59362 | 7.96 |
| 22 | 36.2006 | 226.31 | 2.48144 | 3.00 |
| 23 | 38.5550 | 208.29 | 2.33516 | 2.76 |

**Tabelle 27: Probe 25: 7,0 g Pigment A und 3,0 g Pigment B (physikalische Mischung 70 Mol-% Kupfer und 30 Mol-% Zink) erfindungsgemäß**

| Peak Number | Pos. [°2Th.] | Height [cts] | d-spacing [Å] | Rel. Int. [%] |
|---|---|---|---|---|
| 1 | 6.4118 | 1153.78 | 13.78546 | 15.65 |
| 2 | 7.2045 | 2669.82 | 12.27027 | 36.22 |
| 3 | 8.3000 | 509.00 | 10.65306 | 6.90 |
| 4 | 10.4359 | 1190.82 | 8.47703 | 16.15 |
| 5 | 11.8520 | 371.87 | 7.46714 | 5.04 |
| 6 | 13.8217 | 694.22 | 6.40715 | 9.42 |
| 7 | 17.2822 | 1499.61 | 5.13122 | 20.34 |
| 8 | 17.7154 | 1596.29 | 5.00670 | 21.65 |
| 9 | 18.2123 | 1429.06 | 4.87119 | 19.38 |
| 10 | 19.8170 | 418.33 | 4.48024 | 5.67 |
| 11 | 20.7214 | 792.59 | 4.28669 | 10.75 |
| 12 | 22.0866 | 369.69 | 4.02471 | 5.01 |
| 13 | 24.1146 | 1329.30 | 3.69064 | 18.03 |
| 14 | 25.8688 | 4264.46 | 3.44421 | 57.85 |
| 15 | 26.6693 | 5999.24 | 3.34262 | 81.38 |
| 16 | 27.0538 | 6814.95 | 3.29598 | 92.44 |
| 17 | 27.9203 | 7372.03 | 3.19563 | 100.00 |
| 18 | 28.5016 | 4982.85 | 3.13177 | 67.59 |
| 19 | 30.2431 | 349.05 | 2.95528 | 4.73 |
| 20 | 31.4582 | 713.16 | 2.84385 | 9.67 |
| 21 | 34.6608 | 718.96 | 2.58807 | 9.75 |
| 22 | 36.1947 | 381.69 | 2.48183 | 5.18 |
| 23 | 38.5652 | 323.59 | 2.33456 | 4.39 |
| 24 | 39.3002 | 474.31 | 2.29258 | 6.43 |

**Tabelle 28: Probe 26: 8,0 g Pigment A und 2,0 g Pigment B (physikalische Mischung 80 Mol-% Kupfer und 20 Mol-% Zink) erfindungsgemäß**

| Peak Number | Pos. [°2Th.] | Height [cts] | d-spacing [Å] | Rel. Int. [%] |
|---|---|---|---|---|
| 1 | 7.1736 | 3055.44 | 12.32300 | 39.07 |
| 2 | 8.3027 | 693.01 | 10.64961 | 8.86 |
| 3 | 10.3681 | 966.90 | 8.53229 | 12.36 |
| 4 | 11.8485 | 464.33 | 7.46933 | 5.94 |
| 5 | 13.8476 | 797.50 | 6.39523 | 10.20 |
| 6 | 17.2646 | 1588.75 | 5.13639 | 20.31 |
| 7 | 17.7574 | 1695.70 | 4.99496 | 21.68 |
| 8 | 18.2119 | 1660.18 | 4.87130 | 21.23 |
| 9 | 19.7901 | 464.73 | 4.48626 | 5.94 |
| 10 | 20.6311 | 632.64 | 4.30524 | 8.09 |
| 11 | 24.1009 | 1677.70 | 3.69271 | 21.45 |
| 12 | 25.9128 | 4767.88 | 3.43847 | 60.96 |
| 13 | 26.7783 | 5681.88 | 3.32927 | 72.65 |
| 14 | 27.0252 | 5907.92 | 3.29941 | 75.54 |
| 15 | 27.9301 | 7821.25 | 3.19453 | 100.00 |
| 16 | 28.4851 | 5438.38 | 3.13354 | 69.53 |
| 17 | 30.2360 | 445.73 | 2.95596 | 5.70 |
| 18 | 31.4464 | 790.60 | 2.84489 | 10.11 |
| 19 | 34.7089 | 846.92 | 2.58459 | 10.83 |
| 20 | 36.1959 | 393.37 | 2.48175 | 5.03 |
| 21 | 38.5885 | 301.64 | 2.33321 | 3.86 |

**Tabelle 29: Probe 27: 9,0 g Pigment A und 1,0 g Pigment B (physikalische Mischung 90 Mol-% Kupfer und 10 Mol-% Zink) erfindungsgemäß**

| Peak Number | Pos. [°2Th.] | Height [cts] | d-spacing [Å] | Rel. Int. [%] |
|---|---|---|---|---|
| 1 | 7.2438 | 2978.94 | 12.20375 | 35.85 |
| 2 | 8.2997 | 597.29 | 10.65348 | 7.19 |
| 3 | 10.4138 | 818.06 | 8.49493 | 9.84 |
| 4 | 11.8301 | 483.66 | 7.48094 | 5.82 |
| 5 | 13.7954 | 1003.71 | 6.41927 | 12.08 |
| 6 | 16.7081 | 634.36 | 5.30622 | 7.63 |
| 7 | 17.2669 | 1677.71 | 5.13572 | 20.19 |
| 8 | 17.7104 | 1929.85 | 5.00809 | 23.22 |
| 9 | 18.2360 | 1876.79 | 4.86494 | 22.58 |
| 10 | 19.7670 | 367.37 | 4.49145 | 4.42 |
| 11 | 20.5166 | 633.88 | 4.32902 | 7.63 |
| 12 | 22.0739 | 502.46 | 4.02701 | 6.05 |
| 13 | 24.0786 | 1759.72 | 3.69608 | 21.17 |
| 14 | 25.9734 | 5031.03 | 3.43058 | 60.54 |
| 15 | 26.9899 | 5288.86 | 3.30364 | 63.64 |
| 16 | 27.9149 | 8310.34 | 3.19624 | 100.00 |
| 17 | 28.4936 | 5610.10 | 3.13263 | 67.51 |
| 18 | 30.2853 | 534.17 | 2.95126 | 6.43 |
| 19 | 31.4675 | 834.42 | 2.84303 | 10.04 |
| 20 | 34.6489 | 988.00 | 2.58893 | 11.89 |
| 21 | 36.2166 | 342.02 | 2.48038 | 4.12 |
| 22 | 38.4879 | 412.43 | 2.33907 | 4.96 |

**Tabelle 30: Probe 28: 9,4 g Pigment A und 0,6 g Pigment B (physikalische Mischung 94 Mol-% Kupfer und 6 Mol-% Zink) erfindungsgemäß**

| Peak Number | Pos. [°2Th.] | Height [cts] | d-spacing [Å] | Rel. Int. [%] |
|---|---|---|---|---|
| 1 | 7.1753 | 3350.61 | 12.32014 | 38.97 |
| 2 | 8.2817 | 668.11 | 10.67651 | 7.77 |
| 3 | 10.5265 | 806.23 | 8.40426 | 9.38 |
| 4 | 11.8039 | 604.03 | 7.49745 | 7.02 |
| 5 | 13.6935 | 880.36 | 6.46684 | 10.24 |
| 6 | 16.6458 | 592.72 | 5.32592 | 6.89 |
| 7 | 17.2455 | 1742.37 | 5.14204 | 20.26 |
| 8 | 17.7072 | 1926.66 | 5.00899 | 22.41 |
| 9 | 18.2064 | 1871.84 | 4.87277 | 21.77 |
| 10 | 19.7574 | 423.71 | 4.49362 | 4.93 |
| 11 | 20.5220 | 596.50 | 4.32789 | 6.94 |
| 12 | 22.0690 | 489.01 | 4.02788 | 5.69 |
| 13 | 24.0892 | 1772.40 | 3.69447 | 20.61 |
| 14 | 25.8122 | 4513.94 | 3.45164 | 52.50 |
| 15 | 25.9620 | 5143.24 | 3.43207 | 59.81 |
| 16 | 26.8991 | 4855.01 | 3.31459 | 56.46 |
| 17 | 27.8947 | 8598.58 | 3.19850 | 100.00 |
| 18 | 28.4773 | 5937.78 | 3.13438 | 69.06 |
| 19 | 30.2362 | 496.99 | 2.95594 | 5.78 |
| 20 | 31.4281 | 914.98 | 2.84651 | 10.64 |
| 21 | 32.7448 | 198.80 | 2.73499 | 2.31 |
| 22 | 34.6599 | 1045.66 | 2.58813 | 12.16 |
| 23 | 36.2789 | 294.79 | 2.47626 | 3.43 |
| 24 | 38.5696 | 462.48 | 2.33431 | 5.38 |
| 25 | 39.5361 | 747.29 | 2.27944 | 8.69 |

## Patentansprüche

1. Metallazopigmente, **dadurch gekennzeichnet, dass** sie enthalten die Komponenten
a) mindestens zwei Metallazoverbindungen die sich mindestens in der Art des Metalls voneinander unterscheiden und die jeweils
• Struktureinheiten der Formel (I), oder deren tautomeren Formen, 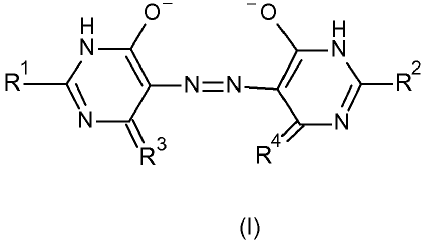 worin
R¹ und R² unabhängig voneinander für OH, NH₂ oder NHR⁵ stehen,
R³ und R⁴ unabhängig voneinander für =O oder =NR⁵ stehen,
R⁵ für Wasserstoff oder Alkyl, vorzugsweise C₁-C₄-Alkyl, steht,
und
• Zn²⁺- beziehungsweise Cu²⁺- Metallionen und gegebenenfalls mindestens ein weiteres Metallion Me,
wobei Me für ein 2- oder 3-wertiges, von Zn²⁺ und Cu²⁺ verschiedenes Metallion steht,
enthalten,
mit der Maßgabe, dass die Menge an Zn²⁺- und Cu²⁺- Metallionen zusammen 95 bis 100 Mol-% beträgt und die Menge an 2- oder 3-wertigen, von Zn²⁺ und Cu²⁺ verschiedenen Metallionen 0 bis 5 Mol-% beträgt, jeweils bezogen auf ein Mol aller Metallionen im Metallazopigment,
und
wobei das Molverhältnis von Zn²⁺- zu Cu²⁺- Metallionen im Metallazopigment 199 : 1 bis 1 : 15, bevorzugt 19 : 1 bis 1 : 1 und besonders bevorzugt 9 : 1 bis 2 : 1,
beträgt,
und
b) mindestens eine Verbindung der Formel (II) 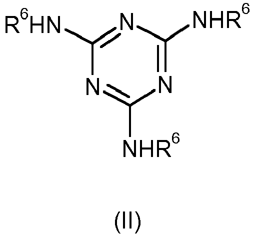 worin
R⁶ für Wasserstoff oder Alkyl, vorzugsweise C₁-C₄-Alkyl das gegebenenfalls ein- oder mehrfach durch OH substituiert ist,
steht.

2. Metallazopigmente gemäß Anspruch 1, **dadurch gekennzeichnet, dass** die Komponenten a) und die Komponenten b) miteinander in Form von Addukten vorliegen.

3. Metallazopigmente gemäß Anspruch 1 oder 2, **dadurch gekennzeichnet, dass** in Formel (I)
R¹ und R² für OH stehen,
und
R³ und R⁴ für =O stehen,
und in Formel (II)
R⁶ für Wasserstoff steht.

4. Metallazopigmente gemäß wenigstens einem der Ansprüche 1 bis 3, **dadurch gekennzeichnet, dass** Me für ein Metallion aus der Reihe Ni²⁺, Al³⁺, Fe²⁺, Fe³⁺, Co²⁺, Co³⁺, La³⁺, Ce³⁺, Pr³⁺, Nd²⁺, Nd³⁺, Sm²⁺, Sm³⁺, Eu²⁺, Eu³⁺, Gd³⁺, Tb³⁺, Dy³⁺, Ho³⁺, Yb²⁺, Yb³⁺, Er³⁺, Tm³⁺, Mg²⁺, Ca²⁺, Sr²⁺, Mn²⁺, Y³⁺, Sc³⁺, Ti²⁺, Ti³⁺, Nb³⁺, Mo²⁺, Mo³⁺, V²⁺, V³⁺, Zr²⁺, Zr³⁺, Cd²⁺, Cr³⁺, Pb²⁺, Ba²⁺, besonders bevorzugt aus der Reihe Al³⁺, Fe²⁺, Fe³⁺, Co²⁺, Co³⁺, La³⁺, Ce³⁺, Pr³⁺, Nd³⁺, Sm³⁺, Eu³⁺, Gd³⁺, Tb³⁺, Dy³⁺, Ho³⁺, Yb³⁺, Er³⁺, Tm³⁺, Mg²⁺, Ca²⁺, Sr²⁴, Mn²⁺, Y³⁺, ganz besonders bevorzugt aus der Reihe Al³⁺, Fe²⁺, Fe³⁺, Co²⁺, Co³⁺, La³⁺, Ce³⁺, Pr³⁺, Nd³⁺, Sm³⁺, Tb³⁺, Ho³⁺, Sr²⁺ und insbesondere aus der Reihe Al³⁺, Fe²⁺, Fe³⁺, Co²⁺ und Co³⁺ steht.

5. Metallazopigmente gemäß wenigstens einem der Ansprüche 1 bis 4, **dadurch gekennzeichnet, dass** die Menge an Cu²⁺- und Zn²⁺- Metallionen zusammen100 Mol-% beträgt, bezogen auf ein Mol aller Metallionen.

6. Metallazopigmente gemäß wenigstens einem der Ansprüche 1 bis 5, **dadurch gekennzeichnet, dass** pro Mol an Struktureinheiten der Formel (I) 0,05 bis 4 Mol, bevorzugt 0,5 bis 2,5 Mol und ganz besonders bevorzugt 1,0 bis 2,0 Mol an Verbindung der Formel (II) enthalten ist.

7. Metallazopigmente gemäß wenigstens einem der Ansprüche 1 bis 6, **dadurch gekennzeichnet, dass** sie eine spezifische Oberfläche von 20 bis 200 m²/g, bevorzugt von 60 bis 160 m²/g und ganz besonders bevorzugt von 90 bis 150 m²/g besitzen.

8. Metallazopigmente gemäß wenigstens einem der Ansprüche 1 bis 7, **dadurch gekennzeichnet, dass** sie im Röntgendiffraktogramm zwischen den Netzebenenabständen von d = 14,7 (± 0,3) Å und d = 11,8 (± 0,3) Å mindestens ein Signal S mit der Intensität I aufweisen, das den Wert des Untergrundes um das 3-fache der Wurzel dieses Wertes übersteigt.

9. Verfahren zur Herstellung von Metallazopigmenten gemäß wenigstens einem der Ansprüche 1 bis 8, **dadurch gekennzeichnet dass** eine Verbindung der Formel (III), oder deren Tautomere, 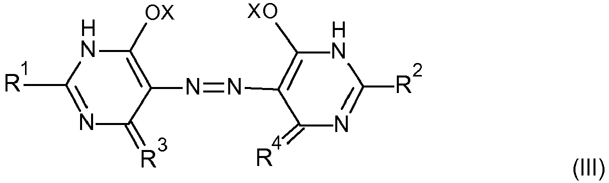 worin
X für ein Alkalimetallion, vorzugsweise für ein Natrium- oder Kaliumion steht,
R¹ und R² unabhängig voneinander für OH, NH₂ oder NHR⁵ stehen,
R³ und R⁴ unabhängig voneinander für =O oder =NR⁵ stehen,
und
R⁵ für Wasserstoff oder Alkyl, vorzugsweise C₁-C₄-Alkyl, steht,
in Gegenwart von mindestens einer Verbindung der Formel (II) 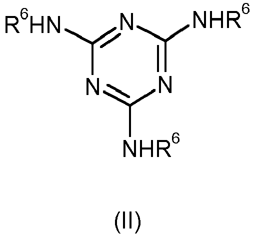 worin
R⁶ für Wasserstoff oder Alkyl, vorzugsweise C₁-C₄-Alkyl das gegebenenfalls ein- oder mehrfach durch OH substituiert ist, steht,
gleichzeitig oder nacheinander mit mindestens einem Zinksalz und mindestens einem Kupfersalz und gegebenenfalls mit mindestens einem weiteren Metallsalz eines 2- oder 3-wertigen, von Zink und Kupfer verschiedenen Metalls, vorzugsweise aus der Reihe der Ni²⁺-, Al³⁺-, Fe²⁺-, Fe³⁺-, Co²⁺-, Co³⁺-, La³⁺-, Ce³⁺-, Pr³⁺-, Nd²⁺-, Nd³⁺-, Sm²⁺-, Sm³⁺-, Eu²⁺-, Eu³⁺-, Gd³⁺-, Tb³⁺-, Dy³⁺-, Ho³⁺-, Yb²⁺-, Yb³⁺-, Er³⁺-, Tm³⁺-, Mg²⁺-, Ca²⁺-, Sr²⁺-, Mn²⁺-, Y³⁺-, Sc³⁺-, Ti²⁺-, Ti³⁺-, Nb³⁺-, Mo²⁺-, Mo³⁺-, V²⁺-, V³⁺-, Zr²⁺-, Zr³⁺-, Cd²⁺-, Cr³⁺-, Pb²⁺- und Ba²⁺- Salze, besonders bevorzugt aus der Reihe Al³⁺-, Fe²⁺-, Fe³⁺, Co²⁺-, Co³⁺-, La³⁺-, Ce³⁺-, Pr³⁺-, Nd³⁺-, Sm³⁺-, Eu³⁺-, Gd³⁺-, Tb³⁺-, Dy³⁺-, Ho³⁺-, Yb³⁺-, Er³⁺-, Tm³⁺-, Mg²⁺-, Ca²⁺-, Sr²⁺-, Mn²⁺- und Y³⁺-Salze , ganz besonders bevorzugt aus der Reihe Al³⁺-, Fe²⁺-, Fe³⁺-, Co²⁺-, Co³⁺-, La³⁺-, Ce³⁺-, Pr³⁺-, Nd³⁺-, Sm³⁺-, Tb³⁺-, Ho³⁺- und Sr²⁺- Salze und insbesondere aus der Reihe Al³⁺-, Fe²⁺-, Fe³⁺-, Co²⁺- und Co³⁺- Salze umsetzt, wobei pro Mol an Verbindung der Formel (III) 0,06 bis 0,995 Mol mindestens eines Zinksalzes, 0,005 bis 0,94 Mol mindestens eines Kupfersalzes und 0,05 bis 0 Mol mindestens eines weiteren Metallsalzes eingesetzt werden, und wobei die Summe der Molmengen dieser Metallsalze insgesamt ein Mol beträgt.

10. Pigmentpräparationen enthaltend wenigstens ein Metallazopigment gemäß wenigstens einem der Ansprüche 1 bis 8 und wenigstens einen Hilfs- und/oder Zusatzstoff, vorzugsweise aus der Reihe der oberflächenaktiven Mittel, der Oberflächenbelegungsmittel, der Basen und der Lösungsmittel, und gegebenenfalls wenigstens ein weiteres Pigment.

11. Pigmentpräparation gemäß Anspruch 10, **dadurch gekennzeichnet, dass** sie als weiteres Pigment C.I. Pigment Green 36 und/oder C.I. Pigment Green 58 enthält.

12. Verfahren zur Herstellung einer Pigmentpräparation nach wenigstens einem der Ansprüche 10 bis 11, **dadurch gekennzeichnet, dass** wenigstens ein Metallazopigment gemäß wenigstens einem der Ansprüche 1 bis 8 mit wenigstens einem Hilfs- und/ oder Zusatzstoff, vorzugsweise aus der Reihe der oberflächenaktiven Mittel, der Oberflächenbelegungsmittel, der Basen und der Lösungsmittel, und gegebenenfalls mit wenigstens einem weiteren Pigment vermischt oder vermahlen wird.

13. Verwendung eines Metallazopigments gemäß wenigstens einem der Ansprüche 1 bis 8 zur Herstellung von Pigmentpräparationen.

14. Verwendung eines Metallazopigments gemäß wenigstens einem der Ansprüche 1 bis 8 oder einer Pigmentpräparation gemäß wenigstens einem der Ansprüche 10 bis 11 zur Einfärbung von Ink Jet Tinten, Farbfiltern für Flüssigkristallanzeigen, Druckfarben, Leimfarben oder Binderfarben, für die Massefärbung von synthetischen, halbsynthetischen oder natürlichen makromolekularen Stoffen, insbesondere Polyvinylchlorid, Polystyrol, Polyamid, Polyethylen oder Polypropylen, sowie für die Spinnfärbung von natürlichen, regenerierten oder künstlichen Fasern, wie z.B. Cellulose-, Polyester-, Polycarbonat-, Polyacrylnitril- oder Polyamidfasern, sowie zum Bedrucken von Textilien und Papier.

15. Farbfilter, Photolack, Drucktinte oder Flüssigkristallanzeige enthaltend wenigstens ein Metallazopigment gemäß wenigstens einem der Ansprüche 1 bis 8 oder eine Pigmentpräparation gemäß wenigstens einem der Ansprüche 10 bis 11.

16. Photolack enthaltend wenigstens ein Metallazopigment gemäß wenigstens einem der Ansprüche 1 bis 8, oder eine Pigmentpräparation gemäß wenigstens einem der Ansprüche 10 bis 11, und ein oder mehrere photohärtbare Monomere und ein oder mehrere Photoreaktionsstarter und gegebenenfalls ein oder mehrere Binde- oder Dispergiermittel und/oder Lösungsmittel.

17. Verfahren zur Herstellung von Farbfiltern für Flüssigkristallanzeigen umfassend die Schritte a) Auftragen eines Photolacks gemäß Anspruch 16 auf ein Substrat, b) Belichtung mittels Photomaske, c) Härtung und d) Entwicklung zum fertigen farbigen Farbfilter.

## Claims

1. Metal azo pigments, **characterized in that** they comprise the following components:
a) at least two metal azo compounds which differ at least in the type of metal and which each contain
• structural units of the formula (I), or the tautomeric forms thereof, 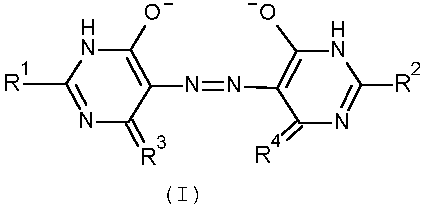 in which
R¹ and R² are each independently OH, NH₂ or NHR⁵,
R³ and R⁴ are each independently =O or =NR⁵,
R⁵ is hydrogen or alkyl, preferably C₁-C₄-alkyl, and
• Zn²⁺ and/or Cu²⁺ metal ions and optionally at least one further metal ion Me,
where Me is a di- or trivalent metal ion other than Zn²⁺ and Cu²⁺,
with the proviso that the amount of Zn²⁺ and Cu²⁺ metal ions together is 95 to 100 mol% and the amount of di- or trivalent metal ions other than Zn²⁺ and Cu²⁺ is 0 to 5 mol%, based in each case on one mole of all metal ions in the metal azo pigment,
and
where the molar ratio of Zn²⁺ to Cu²⁺ metal ions in the metal azo pigment is 199:1 to 1:15, preferably 19:1 to 1:1 and more preferably 9:1 to 2:1,
and
b) at least one compound of the formula (II) 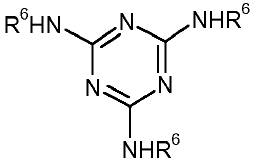 in which
R⁶ is hydrogen or alkyl, preferably C₁-C₄-alkyl optionally mono- or polysubstituted by OH.

2. Metal azo pigments according to Claim 1, **characterized in that** components a) and components b) are present together in the form of adducts.

3. Metal azo pigments according to Claim 1 or 2, **characterized in that**, in formula (I),
R¹ and R² are OH,
and
R3 and R4 are =O,
and, in formula (II),
R6 is hydrogen.

4. Metal azo pigments according to at least one of Claims 1 to 3, **characterized in that** Me is a metal ion from the group of Ni²⁺, Al³⁺, Fe²⁺, Fe³⁺, Co²⁺, Co³⁺, La³⁺, Ce³⁺, Pr³⁺, Nd²⁺, Nd³⁺, Sm²⁺, Sm³⁺, Eu²⁺, Eu³⁺, Gd³⁺, Tb³⁺, Dy³⁺, Ho³⁺, Yb²⁺, Yb³⁺, Er³⁺, Tm³⁺, Mg²⁺, Ca²⁺, Sr²⁺, Mn²⁺, Y³⁺SC³⁺, Ti²⁺, Ti³⁺, Nb³⁺, Mo²⁺, Mo³⁺, V²⁺, V³⁺, Zr²⁺, Zr³⁺, Cd²⁺, Cr³⁺, Pb²⁺, Ba²⁺, more preferably from the group of Al³⁺, Fe²⁺, Fe³⁺, Co²⁺, Co³⁺, La³⁺, Ce³⁺, Pr³⁺, Nd³⁺, Sm³⁺, Eu³⁺, Gd³⁺, Tb³⁺, Dy³⁺, Ho³⁺, Yb³⁺, Er³⁺, Tm³⁺, Mg²⁺, Ca²⁺, Sr²⁺, Mn²⁺, Y³⁺, most preferably from the group of Al³⁺, Fe²⁺, Fe³⁺, Co²⁺, Co³⁺, La³⁺, Ce³⁺, Pr³⁺, Nd³⁺, Sm³⁺, Tb³⁺, Ho³⁺, Sr²⁺ and especially from the group of Al³⁺, Fe²⁺, Fe³⁺, Co²⁺ and Co³⁺.

5. Metal azo pigments according to at least one of Claims 1 to 4, **characterized in that** the amount of Cu²⁺ and Zn²⁺ metal ions together is 100 mol%, based on one mole of all metal ions.

6. Metal azo pigments according to at least one of Claims 1 to 5, **characterized in that** 0.05 to 4 mol, preferably 0.5 to 2.5 mol and most preferably 1.0 to 2.0 mol of compounds of the formula (II) is present per mole of structural units of the formula (I).

7. Metal azo pigments according to at least one of Claims 1 to 6, **characterized in that** they have a specific surface area of 20 to 200 m²/g, preferably of 60 to 160 m²/g and most preferably of 90 to 150 m²/g.

8. Metal azo pigments according to at least one of Claims 1 to 7, **characterized in that**, in the x-ray diffractogram, between the interplanar spacings of d = 14.7 (± 0.3) Å and d = 11.8 (± 0.3) Å, they have at least one signal S having the intensity I which exceeds the background value by 3 times the square root of this value.

9. Process for producing metal azo pigments according to at least one of Claims 1 to 8, **characterized in that** a compound of the formula (III), or tautomers thereof, 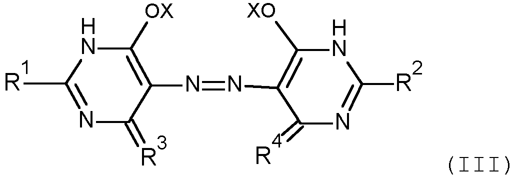 in which
X is an alkali metal ion, preferably a sodium or potassium ion,
R¹ and R² are each independently OH, NH₂ or NHR⁵,
R³ and R⁴ are each independently =O or =NR⁵,
and
R⁵ is hydrogen or alkyl, preferably C₁-C₄-alkyl,
in the presence of at least one compound of the formula (II) 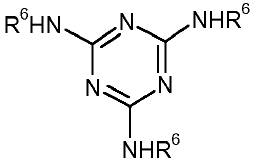 in which
R⁶ is hydrogen or alkyl, preferably C₁-C₄-alkyl optionally mono- or polysubstituted by OH,
is reacted simultaneously or successively with at least one zinc salt and at least one copper salt and optionally with at least one further metal salt of a di- or trivalent metal other than zinc and copper, preferably from the group of the Ni²⁺, Al³⁺, Fe²⁺, Fe³⁺, Co²⁺, Co³⁺, La³⁺, Ce³⁺, Pr³⁺, Nd²⁺, Nd³⁺, Sm²⁺, Sm³⁺, Eu²⁺, Eu³⁺, Gd³⁺, Tb³⁺, Dy³⁺, Ho³⁺, Yb²⁺, Yb³⁺, Er³⁺, Tm³⁺, Mg²⁺, Ca²⁺, Sr²⁺, Mn²⁺, Y³⁺, Sc³⁺, Ti²⁺, Ti³⁺, Nb³⁺, Mo²⁺, Mo³⁺, V²⁺, V³⁺, Zr²⁺, Zr³⁺, Cd²⁺, Cr³⁺, Pb²⁺ and Ba²⁺ salts, more preferably from the group of Al³⁺, Fe²⁺, Fe³⁺, Co²⁺, Co³⁺, La³⁺, Ce³⁺, Pr³⁺, Nd³⁺, Sm³⁺, Eu³⁺, Gd³⁺, Tb³⁺, Dy³⁺, Ho³⁺, Yb³⁺, Er³⁺, Tm³⁺, Mg²⁺, Ca²⁺, Sr²⁺, Mn²⁺ and Y³⁺ salts, most preferably from the group of Al³⁺, Fe²⁺, Fe³⁺, Co²⁺, Co³⁺, La³⁺, Ce³⁺, Pr³⁺, Nd³⁺, Sm³⁺, Tb³⁺, Ho³⁺ and Sr²⁺ salts and especially from the group of Al³⁺, Fe²⁺, Fe³⁺, Co²⁺ and Co³⁺ salts, where 0.06 to 0.995 mol of at least one zinc salt, 0.005 to 0.94 mol of at least one copper salt and 0.05 to 0 mol of at least one further metal salt are used per mole of compound of the formula (III), and where the sum total of the molar amounts of these metal salts together is one mole.

10. Pigment preparations comprising at least one metal azo pigment according to at least one of Claims 1 to 8 and at least one auxiliary and/or additive, preferably from the group of the surface-active agents, the surface-covering agents, the bases and the solvents, and optionally at least one further pigment.

11. Pigment preparation according to Claim 10, **characterized in that** it comprises C.I. Pigment Green 36 and/or C.I. Pigment Green 58 as a further pigment.

12. Process for producing a pigment preparation according to at least one of Claims 10 and 11, **characterized in that** at least one metal azo pigment according to at least one of Claims 1 to 8 is mixed or ground with at least one auxiliary and/or additive, preferably from the group of the surface-active agents, the surface-covering agents, the bases and the solvents, and optionally with at least one further pigment.

13. Use of a metal azo pigment according to at least one of Claims 1 to 8 for production of pigment preparations.

14. Use of a metal azo pigment according to at least one of Claims 1 to 8 or of a pigment preparation according to at least one of Claims 10 and 11 for colouring inkjet inks, colour filters for liquid-crystal displays, printing inks, distempers or emulsion paints, for the bulk colouring of synthetic, semisynthetic or natural macromolecular substances, especially polyvinyl chloride, polystyrene, polyamide, polyethylene or polypropylene, and for the spin dyeing of natural, regenerated or synthetic fibres, for example cellulose, polyester, polycarbonate, polyacrylonitrile or polyamide fibres, and for printing of textiles and paper.

15. Colour filter, photoresist, printing ink or liquid-crystal display comprising at least one metal azo pigment according to at least one of Claims 1 to 8 or a pigment preparation according to at least one of Claims 10 and 11.

16. Photoresist comprising at least one metal azo pigment according to at least one of Claims 1 to 8, or a pigment preparation according to at least one of Claims 10 and 11, and one or more photocurable monomers and one or more reaction photoinitiators and optionally one or more binders or dispersants and/or solvents.

17. Process for producing colour filters for liquid-crystal displays, comprising the steps of a) application of a photoresist according to Claim 16 to a substrate, b) exposure by means of a photomask, c) curing and d) development to give the finished coloured colour filter.

## Revendications

1. Pigments azoïques métalliques, **caractérisés en ce qu'**ils contiennent les composants
a) au moins deux composés azoïques métalliques qui se distinguent au moins par le type du métal et qui contiennent respectivement
• les unités de structure de formule (I), ou leurs formes tautomères, 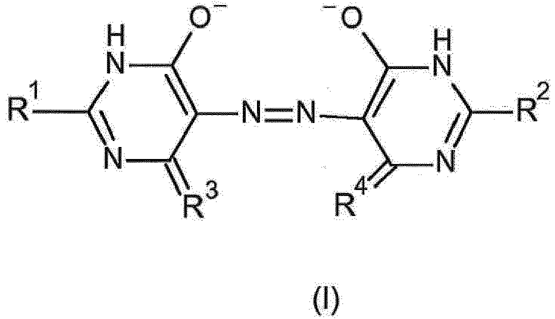 dans laquelle
R¹ et R² représentent, indépendamment l'un de l'autre, OH, NH₂ ou NHR⁵,
R³ et R⁴ représentent, indépendamment l'un de l'autre, =O ou =NR⁵
R⁵ représente hydrogène ou alkyle, de préférence C₁-C₄-alkyle,
et
• ions métalliques Zn²⁺ ou Cu²⁺ et le cas échéant au moins un autre ion métallique Me,
Me représentant un ion métallique divalent ou trivalent qui est différent de Zn²⁺ et Cu²⁺,
à condition que la quantité d'ions métalliques Zn²⁺ et Cu²⁺ ensemble vaille 95 à 100% en mole et la quantité d'ions métalliques divalents ou trivalents qui sont différents de Zn²⁺ et Cu²⁺ vaille 0 à 5% en mole, à chaque fois par rapport à une mole de tous les ions métalliques dans le pigment azoïque métallique,
et
le rapport molaire des ions métalliques Zn²⁺ aux ions métalliques Cu²⁺ dans le pigment azoïque métallique valant 199:1 à 1:15, de préférence 19:1 à 1:1 et de manière particulièrement préférée 9:1 à 2:1,
et
b) au moins un composé de formule (II) 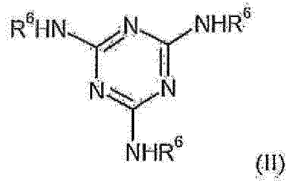 dans laquelle
R⁶ représente hydrogène ou alkyle, de préférence C₁-C₄-alkyle, qui est le cas échéant monosubstitué ou polysubstitué par OH.

2. Pigments azoïques métalliques selon la revendication 1, **caractérisés en ce que** les composants a) et les composants b) sont présents ensemble dans la forme d'adducts.

3. Pigments azoïques métalliques selon la revendication 1 ou 2, **caractérisés en ce que**, dans la formule (I),
R¹ et R² représentent OH et
R³ et R⁴ représentent =O ;
et, dans la formule (II),
R⁶ représente hydrogène.

4. Pigments azoïques métalliques selon au moins l'une quelconque des revendications 1 à 3, **caractérisés en ce que** Me représente un ion métallique de la série Ni²⁴, Al³⁺, Fe²⁺, Fe³⁺, Co²⁺, Co³⁺, La³⁺, Ce³⁺, Pr³⁺, Nd²⁺, Nd³⁺, Sm²⁺, Sm³⁺, Eu²⁺, Eu³⁺, Gd³⁺, Tb³⁺, Dy³⁺, Ho³⁺, Yb²⁺, Yb³⁺, Er³⁺, Tm³⁺, Mg²⁺, Ca²⁺, Sr²⁺, Mn²⁺, Y³⁺, Se³⁺, Ti²⁺, Ti³⁺, Nb³⁺, Mo²⁺, Mo³⁺, V²⁺, V³⁺, Zr²⁺, Zr³⁺, Cd²⁺, Cr³⁺, Pb²⁺, Ba²⁺, de manière particulièrement préférée de la série de Al³⁺, Fe²⁺, Fe³⁺, Co²⁺, Co³⁺, La³⁺, Ce³⁺, Pr³⁺, Nd³⁺, Sm³⁺, Eu³⁺, Gd³⁺, Tb³⁺, Dy³⁺, Ho³⁺, Yb³⁺, Er³⁺, Tm³⁺, Mg²⁺, Ca²⁺, Sr²⁺, Mn²⁺, Y³⁺, de manière tout particulièrement préférée de la série de Al³⁺, Fe²⁺, Fe³⁺, Co²⁺, Co³⁺, La³⁺, Ce³⁺, Pr³⁴, Nd³⁺, Sm³⁺, Tb³⁺, Ho³⁺, Sr²⁺ et en particulier de la série de Al³⁺, Fe²⁺, Fe³⁺, Co²⁺ et Co³⁺.

5. Pigments azoïques métalliques selon au moins l'une quelconque des revendications 1 à 4, **caractérisés en ce que** la quantité d'ions métalliques Cu²⁺ et Zn²⁺ ensemble vaut 100% en mole par rapport à une mole de tous les ions métalliques.

6. Pigments azoïques métalliques selon au moins l'une quelconque des revendications 1 à 5, **caractérisés en ce que** 0,05 à 4 moles, de préférence 0,5 à 2,5 moles et de manière tout particulièrement préférée 1,0 à 2,0 moles de composé de formule (II) sont contenues par mole d'unités de structure de formule (I).

7. Pigments azoïques métalliques selon au moins l'une quelconque des revendications 1 à 6, **caractérisés en ce qu'**ils présentent une surface spécifique de 20 à 200 m²/g, de préférence de 60 à 160 m²/g et de manière tout particulièrement préférée de 90 à 150 m²/g.

8. Pigments azoïques métalliques selon au moins l'une quelconque des revendications 1 à 7, **caractérisés en ce qu'**ils présentent, dans un diagramme de diffraction de rayons X, entre les distances entre les plans de réseau de d = 14,7 (±0,3) Å et d = 11,8 (± 0,3) Å, au moins un signal S présentant une intensité I qui est supérieure d'un facteur 3 de la racine de cette valeur à la valeur du bruit de fond.

9. Procédé pour la préparation de pigments azoïques métalliques selon au moins l'une quelconque des revendications 1 à 8, **caractérisé en ce qu'**on transforme un composé de formule (III), ou ses tautomères, 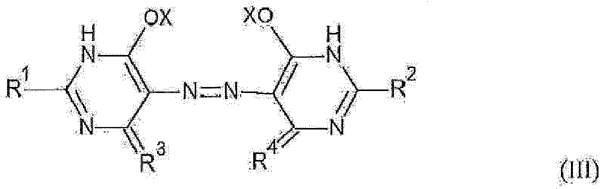 dans laquelle
X représente un ion de métal alcalin, de préférence un ion de sodium ou de potassium,
R¹ et R² représentent, indépendamment l'un de l'autre, OH, NH₂ ou NHR⁵,
R³ et R⁴ représentent, indépendamment l'un de l'autre, =O ou =NR⁵ et
R⁵ représente hydrogène ou alkyle, de préférence C₁-C₄-alkyle
en présence d'au moins un composé de formule (II), 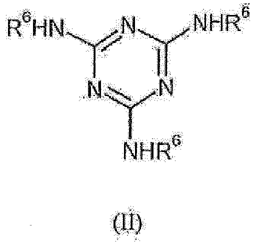 dans laquelle
R⁶ représente hydrogène ou alkyle, de préférence C₁-C₄-alkyle, qui est le cas échéant monosubstitué ou polysubstitué par OH,
simultanément ou successivement avec au moins un sel de zinc et au moins un sel de cuivre et le cas échéant avec au moins un autre sel métallique d'un métal divalent ou trivalent qui est différent de zinc et de cuivre, de préférence de la série des sels de Ni²⁺, Al³⁺, Fe²⁺, Fe³⁺, Co²⁺, Co³⁺, La³⁺, Ce³⁺, Pr³⁺, Nd²⁺, Nd³⁺, Sm²⁺, Sm³⁺, Eu²⁺, Eu³⁺, Gd³⁺, Tb³⁺, Dy³⁺, Ho³⁺, Yb²⁺, Yb³⁺, Er³⁺, Tm³⁺, Mg²⁺, Ca²⁺, Sr²⁺, Mn²⁺, Y³⁺, Sc³⁺, Ti²⁺, Ti³⁺, Nb³⁺, Mo²⁺, Mo³⁺, V²⁺, V³⁺, Zr²⁺, Zr³⁺, Cd²⁺, Cr³⁺, Pb²⁺ et Ba²⁺, de manière particulièrement préférée de la série des sels de Al³⁺, Fe²⁺, Fe³⁺, Co²⁺, Co³⁺, La³⁺, Ce³⁺, Pr³⁺, Nd³⁺, Sm³⁺, Eu³⁺, Gd³⁺, Tb³⁺, Dy³⁺, Ho³⁺, Yb³⁺, Er³⁺, Tm³⁺, Mg²⁺, Ca²⁺, Sr²⁺, Mn²⁺ et Y³⁺, de manière tout particulièrement préférée de la série des sels de Al³⁺, Fe²⁺, Fe³⁺, Co²⁺, Co³⁺, La³⁺, Ce³⁺, Pr³⁺, Nd³⁺, Sm³⁺, Tb³⁺, Ho³⁺ et Sr²⁺ et en particulier de la série des sels de Al³⁺, Fe²⁺, Fe³⁺, Co²⁺ et Co³⁺, en utilisant, par mole de composé de formule (III), 0,06 à 0,995 mole d'au moins un sel de zinc, 0,005 à 0,94 mole d'au moins un sel de cuivre et 0,05 à 0 mole d'au moins un autre sel métallique et la somme des quantités molaires de ces sels métalliques valant en totale une mole.

10. Préparations pigmentaires contenant au moins un pigment azoïque métallique selon au moins l'une quelconque des revendications 1 à 8 et au moins un adjuvant et/ou additif, de préférence de la série des agents tensioactifs, des agents de revêtement de surface, des bases et des solvants, et le cas échéant au moins un autre pigment.

11. Préparation pigmentaire selon la revendication 10, **caractérisée en ce qu'**elle contient en tant qu'autre pigment du C.I. Pigment Green 36 et/ou du C.I. Pigment Green 58.

12. Procédé pour la production d'une préparation pigmentaire selon au moins l'une quelconque des revendications 10 à 11, **caractérisé en ce qu'**on mélange ou broie au moins un pigment azoïque métallique selon au moins l'une quelconque des revendications 1 à 8 avec au moins un adjuvant et/ou additif, de préférence de la série des agents tensioactifs, des agents de revêtement de surface, des bases et des solvants et le cas échéant avec au moins un autre pigment.

13. Utilisation d'un pigment azoïque métallique selon au moins l'une quelconque des revendications 1 à 8 pour la production de préparations pigmentaires.

14. Utilisation d'un pigment azoïque métallique selon au moins l'une quelconque des revendications 1 à 8 ou d'une préparation pigmentaire selon au moins l'une quelconque des revendications 10 à 11 pour la coloration d'encres pour jet d'encre, de filtres couleur pour des affichages à cristaux liquides, d'encres d'impression, d'encres de collage ou d'encres de liant, pour la coloration en masse de substances macromoléculaires synthétiques, semi-synthétiques ou naturelles, en particulier le poly(chlorure de vinyle), le polystyrène, le polyamide, le polyéthylène ou le polypropylène, ainsi que pour la teinture dans la masse de fibres naturelles, régénérées ou synthétiques, telles que par exemple les fibres de cellulose, de polyester, de polycarbonate, de polyacrylonitrile ou de polyamide ainsi que pour l'impression de textiles et de papier.

15. Filtre couleur, résine photosensible, encre d'empression ou affichage à cristaux liquides contenant au moins un pigment azoïque métallique selon au moins l'une quelconque des revendications 1 à 8 ou une préparation pigmentaire selon au moins l'une quelconque des revendications 10 à 11.

16. Résine photosensible contenant au moins un pigment azoïque métallique selon au moins l'une quelconque des revendications 1 à 8, ou une préparation pigmentaire selon au moins l'une quelconque des revendications 10 à 11, et un ou plusieurs monomères photodurcissables et un ou plusieurs initiateurs de photoréaction et le cas échéant un ou plusieurs liants ou dispersants et/ou solvants.

17. Procédé pour la production de filtres couleur pour affichages à cristaux liquides comportant les étapes a) application d'une résine photosensible selon la revendication 16 sur un substrat, b) éclairage au moyen de photomasque, c) durcissage et d) dévéloppement en filtre couleur coloré fini.
